# EUROPEAN PATENT SPECIFICATION

(11) **EP 3 475 098 B1**
(45) Date of publication and mention of the grant of the patent: **08.12.2021**
(21) Application number: 17725731.8
(22) Date of filing: 17.05.2017
(51) Int. Cl.: B42D 25/44, B42D 25/445, B42D 25/373, B42D 25/351, B42D 25/342, B42D 25/324, B42D 25/29, B42D 25/24

(54) **METHODS OF MANUFACTURING AN IMAGE PATTERN FOR A SECURITY DEVICE**
VERFAHREN ZUR HERSTELLUNG EINER BILDSTRUKTUR FÜR EINE SICHERHEITSVORRICHTUNG
PROCÉDÉS DE FABRICATION DE MOTIF D'IMAGE POUR DISPOSITIF DE SÉCURITÉ

(30) Priority: 22.06.2016 GB 201610903
(43) Date of publication of application: 01.05.2019
(73) Proprietor: De La Rue International Limited, Basingstoke, Hampshire RG22 4BS (GB)
(72) Inventor: LISTER, Adam, Andover Hampshire SP10 2ND (GB)
(74) Representative: Gill Jennings & Every LLP
(86) International application number: PCT/GB2017/051373
(87) International publication number: WO 2017/220960

(56) References cited:
- WO-A1-2013/054117
- WO-A1-2014/207165
- WO-A2-2006/084686
- WO-A2-2011/051670
- US-A1- 2009 317 595

## Description

This invention relates to a method of manufacturing an image pattern for a security device.

Security devices are used for example on documents of value such as banknotes, cheques, passports, identity cards, certificates of authenticity, fiscal stamps and other secure documents, in order to confirm their authenticity.

Articles of value, and particularly documents of value such as banknotes, cheques, passports, identification documents, certificates and licences, are frequently the target of counterfeiters and persons wishing to make fraudulent copies thereof and/or changes to any data contained therein. Typically such objects are provided with a number of visible security devices for checking the authenticity of the object. By "security device" we mean a feature which it is not possible to reproduce accurately by taking a visible light copy, e.g. through the use of standardly available photocopying or scanning equipment. Examples include features based on one or more patterns such as microtext, fine line patterns, latent images, venetian blind devices, lenticular devices, moire interference devices and moire magnification devices, each of which generates a secure visual effect. Other known security devices include holograms, watermarks, embossings, perforations and the use of colour-shifting or luminescent / fluorescent inks. Common to all such devices is that the visual effect exhibited by the device is extremely difficult, or impossible, to copy using available reproduction techniques such as photocopying. Security devices exhibiting non-visible effects such as magnetic materials may also be employed. One class of security devices are those which produce an optically variable effect, meaning that the appearance of the device is different at different angles of view. Such devices are particularly effective since direct copies (e.g. photocopies) will not produce the optically variable effect and hence can be readily distinguished from genuine devices. Optically variable effects can be generated based on various different mechanisms, including holograms and other diffractive devices, moire interference and other mechanisms relying on parallax such as venetian blind devices, and also devices which make use of focusing elements such as lenses, including moire magnifier devices, integral imaging devices and so-called lenticular devices.

Moire magnifier devices (examples of which are described in EP-A-1695121, WO-A-94/27254, WO-A-2011/107782 and WO2011/107783) make use of an array of focusing elements (such as lenses or mirrors) and a corresponding array of microimages, wherein the pitches of the focusing elements and the array of microimages and/or their relative locations are mismatched with the array of focusing elements such that a magnified version of the microimages is generated due to the moire effect. Each microimage is a complete, miniature version of the image which is ultimately observed, and the array of focusing elements acts to select and magnify a small portion of each underlying microimage, which portions are combined by the human eye such that the whole, magnified image is visualised. This mechanism is sometimes referred to as "synthetic magnification". The magnified array appears to move relative to the device upon tilting and can be configured to appear above or below the surface of the device itself. The degree of magnification depends, inter alia, on the degree of pitch mismatch and/or angular mismatch between the focusing element array and the microimage array.

Integral imaging devices are similar to moire magnifier devices in that an array of microimages is provided under a corresponding array of lenses, each microimage being a miniature version of the image to be displayed. However here there is no mismatch between the lenses and the microimages. Instead a visual effect is created by arranging for each microimage to be a view of the same object but from a different viewpoint. When the device is tilted, different ones of the images are magnified by the lenses such that the impression of a three-dimensional image is given.

"Hybrid" devices also exist which combine features of moire magnification devices with those of integral imaging devices. In a "pure" moire magnification device, the microimages forming the array will generally be identical to one another. Likewise in a "pure" integral imaging device there will be no mismatch between the arrays, as described above. A "hybrid" moire magnification / integral imaging device utilises an array of microimages which differ slightly from one another, showing different views of an object, as in an integral imaging device. However, as in a moire magnification device there is a mismatch between the focusing element array and the microimage array, resulting in a synthetically magnified version of the microimage array, due to the moire effect, the magnified microimages having a three-dimensional appearance. Since the visual effect is a result of the moire effect, such hybrid devices are considered a subset of moire magnification devices for the purposes of the present disclosure. In general, therefore, the microimages provided in a moire magnification device should be substantially identical in the sense that they are either exactly the same as one another (pure moire magnifiers) or show the same object/scene but from different viewpoints (hybrid devices).

Moire magnifiers, integral imaging devices and hybrid devices can all be configured to operate in just one dimension (e.g. utilising cylindrical lenses) or in two dimensions (e.g. comprising a 2D array of spherical or aspherical lenses).

Lenticular devices on the other hand do not rely upon magnification, synthetic or otherwise. An array of focusing elements, typically cylindrical lenses, overlies a corresponding array of image sections, or "slices", each of which depicts only a portion of an image which is to be displayed. Image slices from two or more different images are interleaved and, when viewed through the focusing elements, at each viewing angle, only selected image slices will be directed towards the viewer. In this way, different composite images can be viewed at different angles. However it should be appreciated that no magnification typically takes place and the resulting image which is observed will be of substantially the same size as that to which the underlying image slices are formed. Some examples of lenticular devices are described in US-A-4892336, WO-A-2011/051669, WO-A-2011051670, WO-A-2012/027779 and US-B-6856462. More recently, two-dimensional lenticular devices have also been developed and examples of these are disclosed in British patent application numbers 1313362.4 and 1313363.2. Lenticular devices have the advantage that different images can be displayed at different viewing angles, giving rise to the possibility of animation and other striking visual effects which are not possible using the moire magnifier or integral imaging techniques.

Security devices such as microtext (and other micrographics), moire magnifiers, integral imaging devices and lenticular devices, as well as others such as venetian blind type devices (which utilise a masking grid in place of focusing elements) and moire interference devices depend for their success significantly on the resolution with which the image array (defining for example microimages, interleaved image sections or line patterns) can be formed. In the case of micrographics, high resolution is essential in order to create recognisable shapes, e.g. letters and numbers, at a sufficiently small size. In moire magnifiers and the like, since the security device must be thin in order to be incorporated into a document such as a banknote, any focusing elements required must also be thin, which by their nature also limits their lateral dimensions. For example, lenses used in such security elements preferably have a width or diameter of 50 microns or less, e.g. 30 microns. In a lenticular device this leads to the requirement that each image element must have a width which is at most half the lens width. For example, in a "two channel" lenticular switch device which displays only two images (one across a first range of viewing angles and the other across the remaining viewing angles), where the lenses are of 30 micron width, each image section must have a width of 15 microns or less. More complicated lenticular effects such as animation, motion or 3D effects usually require more than two interlaced images and hence each section needs to be even finer in order to fit all of the image sections into the optical footprint of each lens. For instance, in a "six channel" device with six interlaced images, where the lenses are of 30 micron width, each image section must have a width of 5 microns or less.

Similarly high-resolution image elements are also required in moire magnifiers and integral imaging devices since approximately one microimage must be provided for each focusing element and again this means in effect that each microimage must be formed within a small area of e.g. 30 by 30 microns. In order for the microimage to carry any detail, fine linewidths of 5 microns or less are therefore highly desirable.

The same is true for many security devices which do not make use of focusing elements, e.g. venetian blind devices and moire interference devices which rely on the parallax effect caused when two sets of elements on different planes are viewed in combination from different angles. In order to perceive a change in visual appearance upon tilting over acceptable angles, the aspect ratio of the spacing between the planes (which is limited by the thickness of the device) to the spacing between image elements must be high. This in practice requires the image elements to be formed at high resolution to avoid the need for an overly thick device.

Typical processes used to manufacture image patterns for security devices are based on printing and include intaglio, gravure, wet lithographic printing as well as dry lithographic printing. The achievable resolution is limited by several factors, including the viscosity, wettability and chemistry of the ink, as well as the surface energy, unevenness and wicking ability of the substrate, all of which lead to ink spreading. With careful design and implementation, such techniques can be used to print pattern elements with a line width of between 25 µm and 50 µm. For example, with gravure or wet lithographic printing it is possible to achieve line widths down to about 15 µm.

Methods such as these are limited to the formation of single-colour image elements, since it is not possible to achieve the high registration required between different workings of a multi-coloured print. In the case of a lenticular device for example, the various interlaced image sections must all be defined on a single print master (e.g. a gravure or lithographic cylinder) and transferred to the substrate in a single working, hence in a single colour. The various images displayed by the resulting security device will therefore be monotone, or at most duotone if the so-formed image elements are placed against a background of a different colour.

One approach which has been put forward as an alternative to the printing techniques mentioned above is used in the so-called Unison Motion^{™} product by Nanoventions Holdings LLC, as mentioned for example in WO-A-2005052650. This involves creating pattern elements ("icon elements") as recesses in a substrate surface before spreading ink over the surface and then scraping off excess ink with a doctor blade. The resulting inked recesses can be produced with line widths of the order of 2 µm to 3 µm. This high resolution produces a very good visual effect, but the process is complex and expensive. Further, limits are placed on the minimum substrate thickness by the requirement to carry recesses in its surface. Again, this technique is only suitable for producing image elements of a single colour.

WO-A-2013/054117 discloses an alternative method for forming a pattern utilising a vesicular film which is exposed to UV light through a mask and then heated, resulting in patterned increased in optical density due to the formation of bubbles within the film.

Other approaches involve the patterning of a metal layer through the use of a photosensitive resist material and exposing the resist to appropriate radiation through a mask. Depending on the nature of the resist material, exposure to the radiation either increases or decreases its solubility in certain etchants, such that the pattern on the mask is transferred to the metal layer when the resist-covered metal substrate is subsequently exposed to the etchant. For instance, EP-A-0987599 discloses a negative resist system in which the exposed photoresist becomes insoluble in the etchant upon exposure to ultraviolet light. The portions of the metal layer underlying the exposed parts of the resist are thus protected from the etchant and the final pattern formed in the metal layer is the "negative" of that carried on the mask. In contrast, our British patent application no. 1510073.9 discloses a positive resist system in which the exposed photoresist becomes more soluble in the etchant upon exposure to ultraviolet light. The portions of the metal layer underlying the unexposed parts of the resist are thus protected from the etchant and the final pattern formed in the metal layer is the same as that carried on the mask. WO-A-2014/207165, WO-A-2006/084686 and US-A-2009/0317595 each discloses methods of patterning a metal layer by modulating the degree to which different parts of a resist layer are exposed to curing radiation, either through use of a decorative ply which acts as a mask, or by providing the metal layer itself with different relief structures (and hence transmissivity to the radiation) in different areas. Methods such as these offer good pattern resolution, but further improvement would still be desirable.

In accordance with the present invention, a method of manufacturing an image pattern for a security device is defined in claim 1.

By using the protrusion(s) of a relief structure to physically remove portion(s) of the resist layer, and subsequently etching the substrate to dissolve the resulting exposed metal, the presently disclosed method offers a new technique for the formation of image patterns, which is particularly well suited for manufacturing high resolution patterns of the sort required for security devices. In particular, it has been found that the presently disclosed method can achieve good edge definition since, rather than relying upon a solubility contrast between radiation-exposed and non-exposed parts of a photosensitive resist as in some previous methods, the resist material is already substantially absent in the desired regions at the point of etching. As a result the exposed metal can be directly and quickly dissolved by the etchant whilst the metal protected by the resist remains in place. Most significantly, a wider range of resist materials can be used in the present method since it is not essential for the resist material to be photosensitive (although this may be preferred), which in turn makes the method suitable for use in patterning a wider range of metals since these may require different etchants and hence different resists. For instance, the presently disclosed method lends itself well to the use of resists comprising highly cross-linked resins with particularly high etch (caustic) resistance, leading to very sharp edge contrast.

The relief structure typically acts to expel the resist material from the at least one region by pushing the resist material into neighbouring areas of the metallised substrate and/or off the substrate area. (It should be appreciated that the at least one region covers less than the whole area of the substrate, and so does the sum of all the regions, so that there will always be some resist material left on the metal layer at the end of step (e)). For example, in preferred implementations, the protrusion(s) wipe the resist material off the metal layer in the at least one region. As a result of this process, the resist material may fill or partially fill the troughs of the relief structure (i.e. those parts between or adjacent the protrusion(s)). However, the aim is not to accurately reproduce the relief structure in the resist layer since this is not necessary to achieve the desired demetallisation. Whilst this could occur in some implementations, more preferably, after step (f), the resist layer has a surface profile which does not match that of the surface relief (i.e. in mirror form). For instance, typically the width of the gap(s) in the resist layer (i.e. the regions where the resist material has been removed) may be wider in the movement direction than the corresponding dimension of the protrusion(s) in the relief structure which formed the gap(s), due to the relative motion between the substrate and at least the tips of the relief structure whilst in contact. Similarly, the areas between the gaps may be narrower in the movement direction than the troughs in the relief structure, for the same reason. In addition, the resist material may not fill the whole of each trough and so its maximum height and shape may not correspond to those of the trough.

It should be noted that the required relative movement may be between only the tips of the protrusions and the metallised substrate, or the whole of each protrusion may move relative to the substrate, or the whole relief structure may move relative to each substrate. If the relief structure is formed at least in part of a flexible material then any of these three options are feasible whereas if the relief structure is rigid then only the third option applies. Relative movement between the various components can be achieved in a number of ways as will be exemplified further below but include (where the relief structure is flexible, at least in part) applying a pressure between the relief structure and the metallised substrate ― this causes the protrusion tips to deform against the metal surface resulting in a flexing of the protrusion against the surface and hence relative motion. Alternatively or additionally, relative motion can be achieved by conveying the relief structure and/or metallised substrate at different relative speeds or even in different directions to one another.

The resist material could be selected from various different types provided that it is sufficiently deformable at the start of step (c) for the resist layer to receive the at least one protrusion therein (without fracturing or cracking in a brittle manner) and for the resist material to be removed from the region(s) by the action of step (d), and subsequently remains only outside the region(s). For instance, the resist material could be a fluid, a gel or a plastically-deformable solid at this stage of the process, or a thermoplastic type material which softens under heating (which could take place just before and/or during contact with the relief structure) and re-hardens upon subsequent cooling (which could take place during contact with the relief structure, e.g. by arranging it on a chill roller, or subsequently). In some cases the composition of the resist material may need no treatment (beyond applying it to the metal surface) to perform the necessary functions required of it in steps (c) to (f). However, more generally it may be necessary to carry out one or more additional treatment steps during the method in order to change the properties of the resist material to better suit the various different steps.

Thus, in a particularly preferred embodiment, the resist material is a curable resist material, preferably a radiation-curable resist material or a heat-curable resist material. For instance, the resist material may be a UV-curable resist material. The resist material may comprise one or more cross-linking agents which, when activated by heat and/or appropriate radiation, promote the formation of cross-links between polymer molecules, thereby hardening the resist. The use of a curable resist material allows the resist material to be applied as a fluid (preferably with low viscosity as detailed below) in step (b), which helps to achieve better spreading of the resist material over the surface of the metal layer as well as a thinner resist layer thickness, and subsequently hardened to prevent the resist material spreading back into the regions from which it has been removed in step (d). Hence, preferably, the method further comprises, during or after steps (d) and/or (e) and before step (f), curing the resist material remaining on the metallised substrate outside the first region(s). For instance, curing could take place during all or part of step (d), e.g. by heating the resist material and/or by exposing it to appropriate radiation, optionally through the resist structure (which may be at least partially transparent for this purpose as explained below). This approach has the advantage that by the time the resist layer is separated from the relief structure in step (e), it will be relatively solid (compared with its nature at the start of step (d)) such that there will be little, if any, spreading of the resist material upon removal of the protrusion(s). Alternatively or in addition, curing may take place after separation of the resist layer and the relief material. This may be appropriate where the resist material is of an intrinsically higher viscosity such that spreading is slow, and/or where the geometry is such that curing during step (d) is not practicable.

In preferred examples, curing takes place both during step (d) and after separation such that the resist is not fully cured at the point of separation, which improves the ease with which the protrusion(s) are removed from the resist material, and subsequently curing is completed. Particularly preferred examples of suitable curable resist compositions will be given below but generally it is desirable to use a curable resist material which comprises a cross-linkable polymer having at least two or three functional groups (i.e. cross-linking sites) per oligomer. This helps to ensure that curing is fast. However too many functional groups (e.g. 8 or more) may lead to too high an initial viscosity and so can be disadvantageous. (Generally the oligomers, i.e. low molecular weight molecules, are the species on the polymer chains that cross-link together to form the cross-linked network/polymer. It is not necessary for all the oligomers to be at least tri-functional as some of them could be di-functional (such as TPGDA) which would lead to a final crosslinked polymer network being more flexible and the starting solution being less viscous. In practice a mixture of oligomers may be used to strike the right balance of properties.)

It has also been found desirable that the resist material be applied in step (b) in such a way so as to form a relatively thin resist layer in order that it is entirely removed from the relevant region(s) in step (d), without leaving any residual resist material in those region(s). In particular, it is preferred that, in step (b), the first resist layer is applied to a thickness which is less than or equal to the height of the at least one protrusion of the relief structure. (The height of a protrusion is measured along the direction normal to the plane or other surface on which the relief structure sits, from the top of the support, corresponding to the base of the protrusion, to the furthest extremity of the protrusion, corresponding to its tip. Equivalently, the height of the protrusions corresponds to the depth of the intervening troughs. Where there are multiple protrusions, preferably these are all of substantially the same height. If there are protrusions of different heights, the resist layer thickness is preferably less than or equal to the height of the shortest protrusion.) By arranging the resist layer thickness to be less than or equal to the protrusion height, not only is contact between the tip of the protrusion(s) and the metal layer promoted (which assists in "wiping" the resist material off the metal layer) but also the troughs in the relief structure may have space therein to accommodate some or all of the resist material expelled from the region(s) during step (d). In this way, the thickness of the resist layer in the areas outside the regions can be increased by the action of step (d) which in turn leads to improved etch resistance. For example, in particularly preferred implementations, in step (b) the first resist layer is applied to a thickness of between 0.5 and 5 microns, preferably between 1 and 3 microns, most preferably between 1 and 2 microns. In such examples, the height of the protrusions is correspondingly greater than the selected thickness value. The resist can be applied to the metal layer using any suitable printing or coating technique, such as gravure printing. Typically the resist layer will be formed all over the metal layer across the whole substrate (i.e. continuously) but this is not essential and in other cases the resist layer could be applied to selected portions only, e.g. to form a macro-pattern within the bounds of which the above-described image pattern will be formed.

In order to achieve suitably thin resist layers in step (b), the resist material is preferably of a relatively low viscosity when it is applied to the metal layer. For instance, in a preferred example, in step (b), the resist material has a viscosity of 30 to 100 mPaS (measured at room temperature using a cone and plate rheometer or measured on press using a number 2 Zahn cup (24 to 40 secs)) when applied to the metallised substrate to form the resist layer. A viscosity of this level has been found to achieve good spreading of the resist material and hence a desirably thin resist layer. However, such low viscosities may be disadvantageous during formation of the pattern in steps (c), (d) and (e), due to increased spreading of the material. Hence preferably, in step (b), the resist material has a first viscosity level when applied to the metallised substrate to form the resist layer, and step (b) further includes subsequently increasing the viscosity of the resist material to a second viscosity level. That is, once the resist material has been applied to the metal layer and the resist layer formed, it may be treated (actively or passively) so as to increase its viscosity. This can be achieved in various different ways.

In one preferred example, the resist material is applied to the metallised substrate (in step (b)) in diluted form in solution with a solvent and the viscosity is subsequently increased by drying the resist material to remove some or all of the solvent. The drying step could be passive (e.g. allowing the substrate sufficient time at ambient temperature for the solvent to evaporate) but preferably may be promoted actively, e.g. by heating the first resist layer.

In another preferred example, the resist material may be heated before application to the metallised substrate and the viscosity is subsequently increased by cooling the first resist layer. This is of course appropriate only for thermoplastic resist materials and not for instance for heat-curable resist materials. The cooling again could be active or passive.

In a still further example, where the resist material is a curable material, the method could further comprise, after step (b) and before step (c): (b1) partially pre-curing the first resist layer. Again, this can be used to increase the viscosity of the resist material after application and prior to patterning. However, the resist material must remain sufficiently deformable for patterning by the relief structure at the end of step (b1) and so the cure at this stage must be incomplete.

The relief structure could be constructed in various different ways. The protrusion(s) may or may not be integral with the support on which they are carried. The protrusions may or may not be spaced from one another at their bases, in which latter case the support may be substantially entirely covered by protrusions and exposed only at certain points or lines between them, if at all. Desirably, the protrusions are shaped so as to function as blades, wiping the resist material from the metal layer. In particularly preferred examples, the one or more protrusions each have a base on the support and a distal tip, the sides of the protrusion being angled on each side of the tip such that the tip is pointed, the sides preferably being straight at the point of intersection so as to form a sharp tip. Protrusions having a pointed tip (typically extending along a line so as to form a sharp edge rather than a single sharp point) as opposed to a flat or rounded top are beneficial since this shape assists in achieving clean insertion of the at least one protrusion into the first resist layer in step (c) with minimal compression of the resist material towards the metal layer, which can lead to less control over the patterning.

The protrusions could have the form of blades with approximately constant cross-section. However in preferred examples, the one or more protrusions each have a base on the support and a distal tip, the width of the base being greater than the width of the tip. The wider base improves the robustness of the relief structure, providing greater surface area for attachment of the protrusion to the support (whether these are integral or not) and increased stability of the protrusion at the base, whilst still permitting the formation of a narrow, sharp tip. In some particularly preferred implementations, the one or more protrusions have substantially triangular cross-sections. That is, each protrusion may comprise a prism with a triangular cross-section. The long axis of the prism may be rectilinear or may be curved. In further preferred examples, the height of each protrusion is preferably equal to or greater than its narrowest width at the base of the protrusion (which is preferably its width in the movement direction), e.g. to promote flexibility of each protrusion as discussed below.

Preferably, the one or more protrusions each have a length in the movement direction which is shorter than the length of the first resist layer that is brought into contact with the relief structure in step (c). That is, each protrusion is short enough to have at least one edge surface which once inserted into the resist layer is adjacent to a portion of resist material in the movement direction and can therefore push that resist material laterally out of the region of the substrate. If on the other hand the protrusion extends beyond the perimeter of the resist layer brought into contact with it in both senses of the moment direction, there may be no or only minimal removal of resist material.

Desirably, the one or more protrusions each have a lateral shape of which at least part is arranged along a direction which is not parallel with the movement direction. That is, at least the tip of the protrusion has a finite, non-zero length in a direction non-parallel with the movement direction. Again, this increases the ability of the protrusion to push a neighbouring volume of resist material out of the relevant region.

In preferred examples, the one or more protrusions each have a lateral shape in the form of a rectilinear line, a curved line, a dot or an indicia such as alphanumeric characters, symbols, geometric shapes or graphics, preferably line graphics. Typically, the regions formed in step (d), and hence the second pattern elements, will have shapes depending on the lateral shapes of the protrusions and generally corresponding to those lateral shapes, but the correspondence will usually not be exact due to the relative movement between the relief structure and the substrate as mentioned previously. For instance, portions of the protrusion extending in a direction non-parallel to the movement direction will produce wider gaps in the resist layer than will any portions extending parallel to the movement direction. Hence, for example a protrusion in the shape of the letter "O" may form a second pattern element which is a stretched version of the same letter, with its two opposite sides spaced in the machine direction appearing thicker than the two portions which join them.

Advantageously, the one or more protrusions comprises a plurality of protrusions, preferably arranged in a periodic manner on the support. The so-formed array of protrusions may be periodic in the movement direction and/or in the orthogonal direction. In particularly preferred embodiments, the plurality of protrusions comprises a plurality of linear protrusions, arranged periodically in the movement direction. Such configurations have been used to produce corresponding line patterns. The lines could be rectilinear or curved. Straight lines having their long axes extending in the direction orthogonal to the movement direction are particularly preferred. Desirably, the plurality of protrusions are substantially identical to one another.

The relative arrangement of protrusions will depend on the desired image pattern to be produced. However, in advantageous examples, the plurality of protrusions have a periodicity in the movement direction of between 10 and 50 microns, preferably between 15 and 25 microns, still preferably around 20 microns. The protrusions may additionally have regular periodicity in the orthogonal direction, preferably of the same order of magnitude.

The relief structure could be formed of a rigid material, for high robustness and accuracy of replication. However, in more preferred implementations, the one or more protrusions each have a base on the support and a distal tip, at least the tip of the protrusion being formed of a flexible material such that at least the tip deforms during step (d), more preferably the whole of each protrusion being formed of a flexible material, the flexible material preferably comprising an elastomer. For instance, materials with a typical shore hardness of 40 to 70 on the A scale are preferred. Forming the protrusions in this way so that at least the tips thereof are flexible has been found to improve the efficiency with which the protrusions can remove the resist material from the regions in step (d), reducing or eliminating the occurrence of residual resist material in the regions. Use of a flexible material also makes it possible to achieve the necessary relative motion between the protrusion tips and the metallised substrate without requiring the relief structure and substrate to be conveyed at different speeds, as already mentioned above and discussed further below. The protrusions (or at least their tips) may be formed of an elastomeric polymer, for instance.

Advantageously, where the resist material is a radiation-curable resist material, at least the support of the relief structure, and preferably also the one or more protrusions, is substantially transparent to radiation to which the resist material is responsive. This enables the resist material to be cured or partially cured during step (d) by irradiating the material to appropriate radiation through the relief structure. Since the resist material should remain only in the troughs between protrusions, it may be sufficient to irradiate the resist layer through any spaces which exist between the protrusions in which case only the support of the relief structure need be transparent. However, more preferably the whole relief structure is transparent. For instance, if the resist material is a UV curable resist material, the relief structure is preferably UV transparent.

For example, the relief structure could be provided on the surface of a support roller which is at least semi-transparent to radiation to which the resist material is responsive. For example, the support roller may be a quartz or glass cylinder (hollow or solid). A suitable radiation source can be located inside the roller. The relief structure could be either integral with or separable from the support roller. As an alternative or in addition, curing could take place from the opposite side of the substrate, i.e. through the metal layer, if the curing energy source (e.g. UV lamp) is sufficiently strong, or the optical density of the metal layer is low enough.

In step (d), the desired relative motion can be achieved in various ways, depending on the construction of the relief structure. In all implementations, relative motion could be achieved by conveying the relief structure and substrate at different velocities, e.g. by moving only one of the metallised substrate and the relief structure along the movement direction while the other remains stationary, or by moving both items in opposite senses along the movement direction. However, preferably, the metallised substrate and the relief structure are both conveyed in the same sense along the movement direction, at different speeds from one another. This approach enables the resist layer and relief structure to be brought into and out of contact with one another while both in motion with a relatively small velocity difference, thereby improving the amount of control over the patterning procedure.

Preferably, during step (d) a pressure applied between the relief structure and the metallised substrate is sufficient that the tip(s) of the at least one protrusion extends through the first resist layer and contacts the first metal layer. This helps to ensure that all of the resist material is removed from the region(s) by the protrusion(s) without leaving any residual layer.

If at least the tips of the protrusions are formed of a flexible material, an alternative way to achieve the relative motion is by flexing the protrusions against the metal surface. Then, it is preferable that during step (d), the pressure applied between the relief structure and the metallised substrate is such that the tip(s) of the at least one protrusion are deformed against the first metal layer, thereby causing relative movement between the tip(s) of the at least one protrusion and the metallised substrate. This further improves the efficiency with which the resist material is removed from the region(s), the metal layer effectively being wiped clean of resist material by the protrusion tip which may for example become bent, flexed or flattened against the metal surface. Most preferably, the deformable material is also transparent to the curing energy, e.g. UV radiation. For instance, a silicone material may be used.

The relief structure could be provided in the form of a plate which is moved towards and away from the resist layer (or vice versa) before and after step (d). This is particularly suitable for batchwise implementations of the method where a finite area of substrate material will be processed at a time. However, in more preferred embodiments, the relief structure is provided on the surface of a cylinder or continuous belt. This enables continuous production of the image pattern if desired.

The size and shape of the second pattern elements formed by the method will depend on several factors, such as the configuration of the relief structure, the relative speed between the substrate and the relief structure, the pressure between the substrate and the relief structure and the viscosity of the resist material (all of which factors are under the control of the person implementing the method). In preferred examples, the relevant factors are controlled such that the one or more second pattern elements have a dimension in the movement direction of 50 microns or less, preferably 30 microns or less, more preferably 10 microns or less, most preferably 5 microns or less.

The method can be used to form a pattern in many different metals through the selection of an appropriate etchant and resist which (at least by step (f)) is substantially insoluble in the selected etchant (i.e. after curing of the resist, if a curable resist is used). In preferred examples, the first etchant substance is alkaline (e.g. sodium hydroxide), and the first metal layer comprises a metal which is soluble in alkaline conditions, preferably aluminium, an aluminium alloy, chromium or a chromium alloy. Other metals, such as copper or copper alloys, may instead be selected, in which case the first etchant substance may be acidic.

The resist layer may remain in-situ in the final image pattern product. In this case it is preferred that the resist layer is transparent (i.e. optically clear), or may carry a coloured tint, e.g. to change the apparent colour of the metal layer. The resist layer could also be made up of multiple areas with different optical characteristics to form a macro pattern, e.g. a multi-coloured image. However, to reduce the overall thickness it may be desirable to remove the resist layer after etching is complete. Hence, preferably, the method further comprises, after step (f): (g) applying a second etchant substance to the substrate to dissolve the remaining first pattern elements of the first resist layer.

In preferred embodiments, the substrate is substantially transparent (i.e. clear, but may carry a coloured tint). For example, the substrate may be formed of a non-fibrous, polymer material such as BOPP. A release layer could optionally be provided between the substrate material and the first metal layer if it is desired to transfer the so-formed image pattern onto a different surface during later processing.

The image pattern produced by the above method is suitable for use in a security device but will be of a single colour corresponding to that of the metal layer unless additional steps are taken. Therefore, in particularly preferred embodiments, the method further comprises, providing a colour layer on the first or second surface of the substrate, the colour layer comprising at least one optically detectable substance provided across the first and second pattern elements in at least one zone of the pattern, such that when viewed from one side of the substrate web, the colour layer is exposed in the second pattern elements between the first pattern elements of the first metal layer.

As detailed further below whilst in most preferred examples the colour layer will exhibit at least one visible colour which is apparent to the naked eye, this is not essential as the optically detectable substance(s) could emit outside the visible spectrum, e.g. being detectable by machine only. In both cases the colour layer provides the optical characteristics exhibited by the image element array in the second pattern elements but since the position, size and shape of those elements have been defined by the metal layer, the colour layer can be applied without the need for a high resolution process, or any registration with the metal layer. The formation of the fine detail in the image pattern is effectively decoupled from the provision of its colour (or other optical characteristics).

The colour layer can be provided at various different stages of the manufacturing method. If the colour layer is to be carried on the second surface of the substrate (optionally via a primer layer), the colour layer could be applied at any time in the process (i.e. before, during or after any of steps (a) to (g)). For instance if the colour layer is formed before performance of the present method it will be present on the substrate web supplied in step (a). However, preferably the colour layer is located on the first surface of the substrate web so that it is closely adjacent the first metal layer, preferably in contact. In some particularly preferred embodiments, the colour layer is applied after step (f) and, if performed, step (g), on the first surface of the substrate over the remaining portions of the metal layer. In this case the substrate will be transparent and the image element array ultimately viewed through it. In other preferred implementations, the colour layer is provided on the metallised substrate web in step (a) between the first metal layer and the substrate on the first surface of the substrate. In this case the substrate need not be transparent since the image element array will not be viewed through it but from the outside. It should of course be appreciated that the colour layer must not interfere with the ability of the resist to protect portions of the metal layer from the etchant, which requires the resist to be in contact with the metal layer. Hence if the colour layer is provided before the resist is applied it must either be underneath the metal layer or on the opposite surface of the substrate.

The colour layer could cover a single zone of the image pattern (which zone preferably does not extend across the whole pattern), in which case within the zone the second pattern elements will possess the optical characteristics of the colour layer whereas outside the zone the second pattern elements may be transparent or may ultimately take on the colour of some underlying substrate. Preferably the periphery of the zone defines an image such as indicia (e.g. an alphanumeric character). In this way, further information can be incorporated into the image array in addition to the optical effect that is to be generated by the pattern elements themselves.

Advantageously, the colour layer comprises a plurality of different optically detectable substances provided across the first and second pattern elements in respective laterally offset zones of the pattern, wherein preferably each zone encompasses a plurality of the first and second pattern elements. In this way the colour (or other optical characteristic) of the second pattern elements will vary across the array, resulting in a multi-coloured effect for example. Since the colour layer does not have to be applied with high resolution, conventional multi-coloured application processes can be used to form the colour layer, e.g. multiple print workings.

The colour layer can therefore take a wide variety of forms depending on the nature of the optical effect that is to be generated. Preferably, the colour layer is configured in the form of an image arising from the arrangement of the zone(s) and/or the shape of the periphery of the zone(s). The image may be highly complex: for example, a full-colour photographic image may be suitable for use in certain lenticular devices (described further below). Alternatively, simpler images such as block colour patterns, optionally defining indicia by way of their outline, are preferred for use in moire magnifier and integral imaging devices (also described below).

As indicated above, the colour layer may possess one or more conventional visible colours but this is not essential. In preferred examples, the optically detectable substance(s) may comprise any of: visibly coloured dyes or pigments; luminescent, phosphorescent or fluorescent substances which emit in the visible or non-visible spectrum; metallic pigments; interference layer structures and interference layer pigments. The term "visible colour" is used herein to refer to all hues detectable by the human eye, including black, grey, white, silver etc., as well as red, green, blue etc. The colour layer may be formed of one or more inks containing the optically detectable substances, suitable for application by printing for example, or could be applied by other means such as vapour deposition (e.g. as in the case of interference layer structures). Preferably, the colour layer is applied by printing, coating or laminating, optionally in more than one working, preferably by any of: laser printing, inkjet printing, lithographic printing, gravure printing, flexographic printing, letterpress or dye diffusion thermal transfer printing. It should be noted that the colour layer could initially be formed on a separate substrate and then laminated to the substrate on which the patterned metal layer is formed.

The colour layer may have sufficient optical density to provide the desired optical characteristics by itself. However in preferred embodiments the method further comprises applying a substantially opaque backing layer to the substrate, such that the colour layer is located between the first metal layer and the substantially opaque backing layer, the substantially opaque backing layer preferably comprising a further metal layer.

The point in the process at which the backing layer is applied will depend on the location of the colour layer relative to the metal layer. If the colour layer is applied over the demetallised pattern on the first surface of the substrate, the backing layer will be applied after the colour layer on the same surface. If the colour layer is provided under the metal layer on the metallised substrate web, the backing layer may also pre-exist in step (a) under the colour layer.

The substantially opaque backing layer improves the appearance of the image element array by obstructing the transmission of light through the array which may otherwise confuse the final visual effect. A reflective material such as a further metal layer is particularly preferred for use as the backing layer in order to enhance the reflective appearance of the second pattern elements. The substantially opaque backing layer is preferably applied across the whole extent of the image pattern including any regions outside the zone(s) of the colour layer. In such regions, if the backing layer is of substantially the same appearance as the patterned metal layer, the contrast between the first and second pattern elements will be reduced or even eliminated. This may be desirable to limit the final visual effect to those zones where the colour layer is provided.

In many embodiments, the metallic colour and reflective nature of the first pattern elements resulting from the metal layer will be desirable. However, in some cases it may be preferred to modify the appearance of the first pattern elements, e.g. to change their colour and/or to reduce the specular nature of the reflection from the first pattern elements (since this can make the appearance of the image pattern overly dependent on the nature of the light source(s) present when the finished device is observed). Therefore, in preferred embodiments, in step (a) the metallised substrate further comprises a filter layer on the first surface, between the substrate material and the metal layer, across at least an area of the substrate. The filter layer will remain at least in the first pattern elements of the finished image array, located between the viewer and the first metal layer, and acts to modify the appearance of the first pattern elements.

If the filter layer is sufficiently translucent, it may be retained across the whole array since any colour layer provided can be viewed through it in the second pattern elements. However, preferably the method further comprises, after step (f), applying a further etchant substance in which the filter layer is more soluble than the metal layer or the resist layer, to thereby remove the portions of the filter layer in the second pattern elements. The metal layer is preferably insoluble in the further etchant substance.

The nature of the filter layer will depend on the desired effect. In preferred cases the filter layer is provided to diffuse the light reflected by the metal layer, thereby improving the light source invariance of the finished device. In this case, the light-diffusing layer preferably comprises at least one colourless or coloured optical scattering material. For example, the light diffusing layer could comprise a scattering pigment dispersed in a binder. This can be used to disguise the metallic construction of the image array and make it have an appearance closer to that of ink. In other cases it may be desirable to retain the metallic appearance but change its colour, in which case the filter layer may comprise a coloured clear material such as a tinted lacquer. This can be used to give one metal the appearance of another, e.g. an aluminium metal layer can be combined with an orange-brown filter layer making the metal layer appear as if it were formed of copper or bronze.

The filter layer could have a uniform appearance across the array so that the first pattern elements all have the same optical characteristics. However, in preferred examples, the filter layer comprises a plurality of different materials arranged in respective laterally offset areas across the array. For instance the layer may be applied in a multi-coloured pattern. This can be used to introduce an additional level of complexity to the final optically variable effect since the first pattern elements will now vary in their optical characteristics. For example, the filter layer may carry a further image.

The filter layer does not need to be of high optical density since the metal layer is substantially opaque. As such the filter layer is desirably thin so as to minimise any undercutting of the filter layer during etching. Preferably, the thickness of the filter layer is equal to or less than the minimum lateral dimension of the first or second pattern elements, preferably half or less. For example, if the pattern includes features having minimum dimensions of 1 micron (e.g. a 1 micron line width), the filter layer preferably has a thickness of 1 micron or less, more preferably 0.5 microns or less.

The first metal layer on the substrate web may be substantially flat resulting in a uniformly reflective appearance. However, to increase the security level still further, the first metal layer may be used to carry additional security features. Preferably, in step (a), the metallised substrate web has an optically variable effect generating relief structure in its first surface, the metal layer conforming to the contours of the relief structure on one or (preferably) both of its sides, wherein the optically variable effect generating relief structure is preferably a diffractive relief structure, most preferably a diffraction grating, a hologram or a kinegram^{™}. Such a structure may be limited to an area of the web away from the demetallised image pattern formed by the method, or may coincide with the array such that at least some of the first pattern elements display the optically variable effect. As already mentioned, in step (a) the metal layer could be provided across the whole surface of the substrate or could be disposed only on selected portions of the substrate, e.g. corresponding to the lateral extent of a desired security device on a security article such as a thread, strip or patch, or on a security document such as a polymer banknote of which the substrate is to form the basis.

The method could be performed batch-wise or sheet-wise on discrete substrates. However, more preferably, the substrate is a substrate web which is continuously conveyed along a transport path during at least steps (c), (d) and (e). This enables the image pattern to be created in high volumes and at high speed. In preferred embodiments this is enabled by providing the relief structure on the surface of a cylinder or continuous belt as mentioned above.

Thus, the manufacturing method is preferably a continuous process performed on a substrate web as it is conveyed from one reel on to another. The substrate web may be supplied in metallised form or the metal layer (and optionally any colour layer, backing layer and/or filter layer) could be applied onto the transparent substrate prior to step (b) as part of the same, in-line process.

The form of the image pattern resulting from the method will depend primarily on the arrangement of protrusions in the surface relief structure, although it will also be influenced by factors including the relative speed between the relief structure and the substrate and the pressure between the two components, as mentioned above. Nonetheless, the look of the final image pattern can be controlled as desired by adjusting all of these factors appropriately. In preferred examples, the pattern of first and second pattern elements is periodic in at least a first dimension and either the first pattern elements are substantially identical to one another and/or the second pattern elements are substantially identical to one another. This will be suitable for use in moire magnification devices (including hybrid devices), integral imaging devices and certain types of lenticular device. As discussed previously, by "substantially identical" we include microimages which depict the same object or scene as of another but from different angles of view.

In some preferred embodiments, each second pattern element defines a microimage, preferably one or more letters, numbers, logos or other symbols, the microimages being substantially identical to one another, and the first pattern elements define a background surrounding the microimages, or vice versa. Such patterns are well adapted for use in moire magnification devices (including hybrid devices) and integral imaging devices. Preferably, the microimages are arranged in a grid pattern, periodic in a first dimension and in a second dimension, wherein the grid pattern is preferably arranged on an orthogonal or hexagonal grid. In order that the image array can be utilised in a security device of desirably small thickness, each microimage preferably occupies an area having a size of 50 microns or less in at least one dimension, preferably 30 microns or less, most preferably 20 microns or less. In order to display detail within the microimages, each microimage preferably has a line width of 10 microns or less, preferably 5 microns or less, most preferably 3 microns or less.

In other preferred embodiments, the first pattern elements may themselves constitute one "channel" of a lenticular device with the second pattern elements providing a second "channel", as will be described further below. The lenticular device may be active in one dimension or two. In the former case, the pattern of first and second pattern elements is preferably a line pattern, periodic in the movement direction which is perpendicular to the direction of the lines, the line pattern preferably being of straight parallel lines, and the width of the lines preferably being substantially equal to the spacing between the lines. In the latter case, the pattern of first and second pattern elements is preferably a grid pattern, periodic in the first dimension and in a second dimension, wherein the grid pattern is preferably arranged on an orthogonal or hexagonal grid, the grid pattern preferably being of dots arranged according to the grid, most preferably square, rectangular, circular or polygonal dots. The grid pattern may preferably constitute a checkerboard pattern for example.

For other lenticular devices, the image pattern may be more complex. For instance, the first pattern elements can be configured to provide parts of multiple images, with the second pattern elements providing the remaining parts of each of those images. In a preferred example, the pattern of first and second pattern elements defines sections of at least two images interleaved with one another periodically in at least a first dimension, each section preferably having a width of 50 microns or less in at least the first dimension, more preferably 30 microns or less, most preferably 20 microns or less. It should be noted in that in such cases the first and second pattern elements themselves may not be arranged periodically since their locations will be defined by the first and second images.

In many cases, a single image pattern manufactured as described above will be adequate for formation of the security device. However in some cases it is advantageous to provide a second image pattern on the opposite surface of the substrate. This can be used to form a second, independent optically variable security effect if an opaque layer exists between the two metal layers or, if the substrate is transparent, the two metal layers may form part of the same security device, e.g. co-operating to form a moire interference device or a venetian blind effect.

Therefore, in preferred embodiments, in step (a) the metallised substrate web further comprises a second metal layer on the second surface of the substrate, and the method further comprises manufacturing a second image element array by performing steps (b) to (f) on the second resist layer.

The second metal layer and resist could be different from the first metal layer and its resist, in which case the two sides of the substrate will need to be processed differently. However in preferred examples, the second resist and the respective etchant substances are of the same composition as the first metal layer, the first resist and the first and second etchant substances, respectively. In this case both sides of the substrate can be etched simultaneously.

The arrangements of the two image patterns will depend on the effects which are to be exhibited by the device(s). In some cases the two patterns may be the same as one another at least in regions of the device. In preferred examples, the respective patterns are adapted to co-operate with one another to exhibit an optically variable effect. For example, the two patterns may form in combination a security device without any additional components (such as focussing elements) required, such as a venetian blind device or a moire interference device. In many cases, the patterns according to which the first and second image arrays are formed are different and/or laterally offset from one another, allowing for the formation of more complex visual effects.

In order to ensure good alignment between the two image patterns, it is strongly preferred that the steps of contacting the first and second resist layers against the respective relief structures, conveying the substrate and/or relief structures, and separating the first and second resist layers from the respective relief structures are performed in register, preferably simultaneously. For example, the second photosensitive resist layer could be brought into contact with a second relief structure provided on one surface of the substrate web at the same time as the first resist layer is brought into contact with the first relief structure on the opposite side of the web. For instance, two opposing rollers each carrying a relief structure on its surface could be used for this purpose.

The so-produced image pattern may by itself constitute a security device, as will be the case for example where the image pattern comprises microtext or other micrographics.

However, in other cases the present invention further provides a method of manufacturing a security device, comprising:
(i) manufacturing an first image pattern using the method described above; and
(ii) providing a viewing component overlapping the first image pattern;
wherein the first image pattern and the viewing component are configured to co-operate to generate an optically variable effect.

The manufacture of such a security device may take place as part of the same process as manufacturing the image pattern, or could be performed separately, e.g. by a different entity. The viewing component could be provided before or after the image pattern is formed. The viewing component may be applied onto the substrate, e.g. by printing, cast-curing or embossing, preferably on the opposite surface from that on which the image pattern is formed. Alternatively the viewing component could be provided on another (at least semi-transparent) substrate to which the image pattern is affixed.

The nature of the viewing component will depend on the type of security device being formed, and could comprise a masking grid or second image pattern as described further below. However in particularly preferred embodiments, the viewing component comprises a focussing element array (e.g. of lenses or mirrors).

In a first preferred example, the security device is a moire magnifier (including hybrid moire magnifier / integral imaging devices). Thus, preferably, the first pattern elements define (substantially identical) microimages and the second pattern elements define a background, or vice versa, such that the image pattern comprises a microimage array, and the pitches of the focusing element array and of the microimage array and their relative orientations are such that the focusing element array co-operates with the microimage array to generate a magnified version of the microimage array due to the moire effect.

In a second preferred example, the security device is a ("pure") integral imaging device. Hence, the first pattern elements define microimages all depicting the same object from a different viewpoint and the second pattern elements define a background, or vice versa, such that the image pattern comprises a microimage array, and the pitches and orientation of the focusing element array and of the microimage array are the same, such that the focusing element array co-operates with the microimage array to generate a magnified, optically-variable version of the object.

In a third preferred example, the security device is a two-channel lenticular device, the pattern being periodic and the first pattern elements being substantially identical to one another (e.g. line or "dot" elements as described above). The periodicity of the focusing element array is substantially equal to or a multiple of that of the pattern, at least in the first direction, and the focusing element array is configured such that each focusing element can direct light from a respective one of the first pattern elements or from a respective one of the second pattern elements therebetween in dependence on the viewing angle, whereby depending on the viewing angle the array of focusing elements directs light from either the array of first pattern elements in which the metal layer is present or from the second pattern elements therebetween in which the metal layer is absent, such that as the device is tilted light is reflected by the metal layer to the viewer by the first pattern elements in combination at a first range of viewing angles and not at a second range of viewing angles. Thus the appearance generated by the first pattern elements corresponds to one channel of the device and that by the second pattern elements to the second channel of the device. If a light-diffusing layer defining an image is provided, this will be displayed by the device at the first range of viewing angles, corresponding to the first channel of the device.

Preferably, the image pattern is provided with a colour layer as described previously, whereby the colour layer is exposed in the second pattern elements, such that as the device is tilted the colour layer is displayed to the viewer by the second pattern elements in combination at the second range of viewing angles and not at the first range of viewing angles. Hence the second channel of the device is defined by the colour layer and if this takes the form of an image, this image will be displayed by the device at the second range of viewing angles. In this case, highly complex colour layers such as full colour photographs are suitable, although simpler images can also be used.

In a fourth example, the security device is a lenticular device with at least two channels, the first and second pattern elements of the image pattern each defining parts of at least two interleaved images as described previously. In such cases it is preferable, though not essential, that the appearance, e.g. colour, of the first pattern elements is uniform across the array, and so is that of the colour layer. For example the finished array may be duotone. The periodicity of the focusing element array is substantially equal to or a multiple of that of the sections of the at least two images defined by the pattern, at least in the first direction, and the focusing element array is configured such that each focusing element can direct light from a respective one of the first image sections or from a respective one of the second image sections therebetween in dependence on the viewing angle, whereby depending on the viewing angle the array of focusing elements directs light from either the array of first image sections or from the second image sections therebetween, such that as the device is tilted the first image is displayed to the viewer by the first image sections in combination at a first range of viewing angles and the second image is displayed to the viewer by the second image sections at a second range of viewing angles. In this case the first image corresponds to the first channel of the device and the second image to the second channel of the device. More than two images could be provided by interleaving sections from each in the same way.

In lenticular devices, preferably the focusing element array is registered to the array of image elements at least in terms of orientation and preferably also in terms of translation.

The optically variable effect exhibited by the security device may be exhibited upon tilting the device just one direction (i.e. a one-dimensional optically variable effect), or in other preferred implementations may be exhibited upon tilting the device in either of two orthogonal directions (i.e. a two-dimensional optically variable effect). Hence preferably the focussing element array comprises focusing elements adapted to focus light in one dimension, preferably cylindrical focusing elements, or adapted to focus light in at least two orthogonal directions, preferably spherical or aspherical focussing elements. Advantageously, the focussing element array comprises lenses or mirrors. In preferred examples, the focusing element array has a one- or two-dimensional periodicity in the range 5-200 microns, preferably 10-70 microns, most preferably 20-40 microns. The focusing elements may been formed for example by a process of thermal embossing or cast-cure replication.

In order for the security device to generate a focused image, preferably at least the metal layer is located approximately in the focal plane of the focusing element array, and if a colour layer is provided, the colour layer is preferably also located approximately in the focal plane of the focusing element array at least in the second pattern elements. It is desirable that the focal length of each focussing element should be substantially the same, preferably to within +/- 10 microns, more preferably +/- 5 microns, for all viewing angles along the direction(s) in which it is capable of focussing light.

As mentioned above, in alternative embodiments the viewing component may comprise a masking grid or a second image pattern. For instance, this configuration may be used to form security devices such as venetian blind effects and moire interference devices. Viewing components of these sorts could be formed by any convenient technique, e.g. printing, but most preferably are manufactured using the same demetallisation process as described above.

Further disclosed is an image pattern for a security device, and a security device each manufactured in accordance with the above-disclosed methods.

Further disclosed is a security article comprising such a security device, wherein the security article is preferably a security thread, strip, foil, insert, transfer element, label or patch.

Also disclosed is a security document comprising an image pattern or a security device, each as described above, or a security article comprising such an image pattern or security device, wherein the security document is preferably a banknote, cheque, passport, identity card, driver's licence, certificate of authenticity, fiscal stamp or other document for securing value or personal identity. In a particularly preferred embodiment, the substrate provided in step (a) of the presently disclosed method itself forms the substrate of a security document, such as a polymer banknote, the metal layer being disposed on the substrate as previously described and one or more opacifying layers being applied to the same substrate to provide a suitable background for printing thereon.

Examples of security devices, image patterns therefor and their methods of manufacture in accordance with the present invention will now be described and contrasted with conventional examples, with reference to the accompanying drawings, in which:
Figure 1 schematically illustrates apparatus for performing a method of manufacturing an image pattern in accordance with a first embodiment of the invention;
Figure 2 is a flow diagram showing steps of the method according to the first embodiment;
Figures 3(a) to (e) are schematic cross-sections of an exemplary substrate at various steps in the method according to the first embodiment;
Figure 4 schematically illustrates apparatus for performing a method of manufacturing an image pattern in accordance with a second embodiment of the invention;
Figure 5 is a flow diagram showing steps of the method according to the second embodiment;
Figure 6 schematically illustrates apparatus for performing a method of manufacturing an image pattern in accordance with a third embodiment of the invention;
Figure 7 is a flow diagram showing steps of the method according to the third embodiment;
Figure 8(a) schematically depicts an exemplary relief structure as may be utilised in methods according to any embodiment of the invention, in perspective view; Figure 8(b) showing an enlarged portion of the exemplary relief structure, in cross-section; and Figure 8(c) illustrating the exemplary relief structure in combination with an exemplary substrate, in use during a method according to an embodiment of the invention;
Figure 9(a) shows in plan view an exemplary substrate prior to the removal of any resist material, illustrating the positions at which protrusions of the relief structure make contact with the substrate in an embodiment of the invention; Figure 9(b) showing the same substrate after relative movement between the substrate and the relief structure, to illustrate the regions from which the resist material has been removed; and Figure 9(c) showing the substrate of Figure 9(b) in perspective view;
Figures 10, 11 and 12 show three further exemplary substrates in plan view, (a) prior to the removal of any resist material and illustrating the positions at which protrusions of the relief structure make contact with the substrate, and (b) after relative movement between the substrate and the relief structure, illustrating the regions from which the resist material has been removed, in three different embodiments of the invention;
Figures 13 and 14 are photographs showing exemplary image patterns produced using methods in accordance with embodiments of the invention;
Figures 15(a) to (e) are schematic cross-sections of different exemplary substrates carrying image patterns thereon, produced in accordance with various embodiments of the invention;
Figure 16 shows a schematic cross-section of another exemplary substrate carrying an image pattern thereon, produced in accordance with another embodiment of the invention;
Figures 17(a) to (c) are schematic cross-sections of three exemplary security devices each comprising an image pattern produced in accordance with embodiments of the invention;
Figure 18(a) illustrates in plan view an exemplary image pattern produced in accordance with an embodiment of the present invention, Figure 18(b) showing in plan view the appearance of a security device produced in accordance with an embodiment of the present invention incorporating the image element array of Figure 18(a), at one viewing angle;
Figure 19(a) illustrates an exemplary image pattern produced in accordance with an embodiment of the invention, and Figure 19(b) shows the appearance of a security device incorporating the image pattern of Figure 19(a);
Figure 20(a) schematically depicts a security device produced in accordance with a further embodiment of the present invention, Figure 20(b) showing a cross-section through the security device, and Figures 20(c) and (d) showing two exemplary images which may be displayed by the device at different viewing angles;
Figures 21, 22 and 23 show three further embodiments of security devices produced in accordance with embodiments of the invention;
Figure 24 schematically illustrates apparatus for performing a method of manufacturing an image pattern in accordance with another embodiment of the invention;
Figure 25 shows a cross section through a security device produced in accordance with another embodiment of the invention;
Figures 26, 27 and 28 show three exemplary articles carrying security devices produced in accordance with embodiments of the present invention (a) in plan view, and (b) in cross-section; and
Figure 29 illustrates a further embodiment of an article carrying a security device produced in accordance with the present invention, (a) in front view, (b) in back view and (c) in cross-section.

The ensuing description will focus on examples of methods of manufacturing image patterns with high resolution, fine detail in the form of image element arrays as required for use in security devices such as moire magnifiers, integral imaging devices and lenticular devices (amongst others). Preferred embodiments of such security devices making use of image element arrays made in accordance with the described method will then be described below. However it should be appreciated that the disclosed methods of manufacturing image patterns can be used to form any high resolution image pattern, as may be suitable for use in other security devices such as microtext or other micrographics.

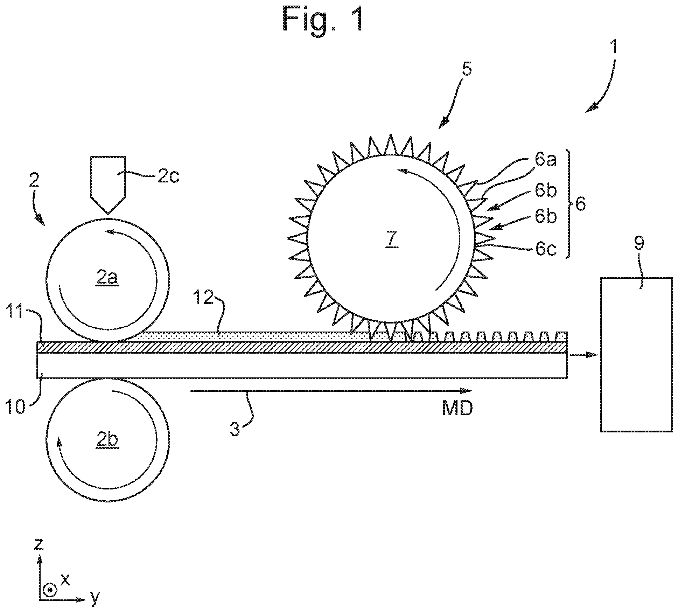

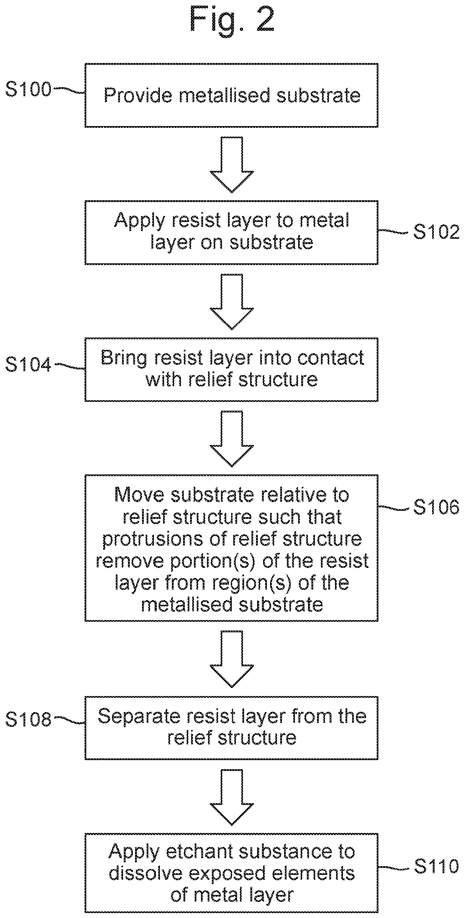

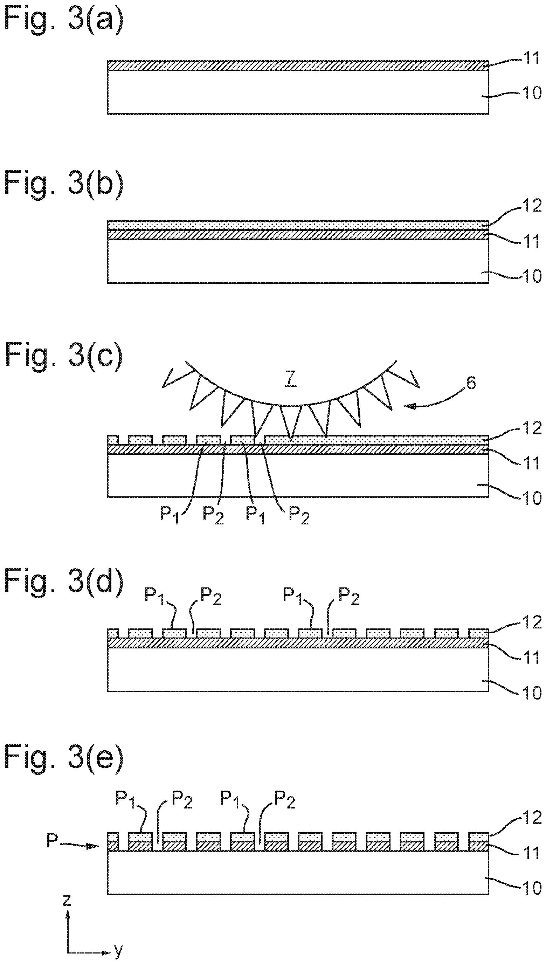

A first embodiment of a method of manufacturing an image pattern will be described with reference to Figures 1, 2 and 3. Figure 1 illustrates exemplary apparatus 1 for performing the method, Figure 2 is a flow diagram setting out steps of the method and Figure 3 shows an exemplary substrate at various stages during the processing thereof in accordance with the method. First, a metallised substrate is provided (step S100), which comprises a (preferably transparent) substrate material 10 carrying a metal layer 11 on one of its surfaces, as shown in Figures 1 and 3(a). The substrate material 10 typically comprises at least one transparent polymeric material, such as BOPP, and may be monolithic or multi-layered. The substrate may be of a type suitable for forming the basis of a security article such as a security thread, strip, patch or transfer foil, or of a type suitable for forming the basis of a security document itself, such as a polymer banknote. The substrate may include additional layers, such as a filter layer (described below) and/or a primer layer underlying the metal layer 11. Alternatively the substrate could be designed as a transfer film in which case a release layer such as wax may be provided between the metal layer 11 and the substrate material 10 so that the image pattern produced using the method can later be transferred to another surface. The substrate could also carry additional security features such as an optically variable relief structure, e.g. a diffraction structure such as a hologram, kinegram or diffraction grating, which the metal layer 11 follows, over all or part of the substrate surface. The substrate may be supplied pre-metallised, or the metal layer 11 (and any optional underlying layer(s)) could be applied as part of the presently disclosed method, e.g. by vapour deposition, sputtering or the like. The metal layer 11 may cover the whole area of the substrate material 10 (as shown) or could be provided only across selected portion(s) of the substrate within which the demetallised pattern is to be formed. Suitable metals include aluminium, copper, chromium and alloys of each (including in particular aluminium-copper alloys). The metal layer 11 is preferably substantially opaque to visible light and is desirably as thin as possible whilst achieving this opacity. The thinner the layer, the more accurately it can be etched since it will be less susceptible to lateral spread of the etched region. In preferred examples, the metal layer 11 may have a thickness of between 10 and 100 nm, more preferably between 10 and 50 nm, most preferably between 10 and 25 nm.

In step S102, a resist material 12 is then applied onto the metal layer 11, by an application station 2, with the result being shown in Figure 3(b). The resist material 12 may be applied all over the substrate area or could be applied selectively, e.g. to define a large-scale pattern or image (sufficiently large to be visible to the naked eye). Suitable application techniques include printing or coating the resist material onto the metal layer. For example, in the exemplary apparatus of Figure 1 the application station 2 comprises a gravure roller 2a which receives resist material from a reservoir 2c (or other inking components such as a suitable roller chain) and transfers it onto the metallised substrate as it is conveyed past. The gravure roller 2a is opposed in this example by an impression roller 2b. Examples of suitable resist materials will be given below but typically may comprise a polymeric material such as a resin, gel or an ink binder (with or without pigment). The resist material remains as a liquid, gel or plastically deformable solid after application to the metal layer for patterning of the resist layer 12, which takes place in step sequence S104, S106 and S108 at patterning station 5.

The resist-coated substrate is conveyed from the application station 2 via a conventional web transport system (not shown, but represented schematically at 3) along a machine direction MD to the patterning station 5 at which the resist layer 12 is brought into contact with a relief structure 6. In this example, the relief structure 6 is carried on the circumferential surface of a cylinder 7 although in other cases the relief structure 6 could be carried on a belt supported between rollers, or in sheet-fed (i.e. non-continuous) implementations of the method the relief structure 6 could be arranged on a plate which is moved towards and away from the substrate. While in contact with one another, the relief structure 6 and the substrate are controlled so as to achieve relative motion between at least the tips of the protrusions and the substrate. In the Figure 1 example, here the cylinder 7 is driven in the same direction as the substrate (MD) but at a different speed meaning that where the relief structure 6 contacts the resist layer 12, there is relative motion between them in the machine direction MD. In this example, the cylinder 7 is driven more slowly than the substrate. In other examples where the relief structure is formed at least in part of a flexible material (described below) such differential conveyancing speeds are not required and the necessary relative movement can be achieved by flexing of the protrusions against the substrate.

The relief structure 6 comprises at least one but more preferably a plurality of protrusions 6a, spaced by troughs 6b, arranged on a support 6c which here corresponds to the surface of cylinder 7. The shape and arrangement of the protrusions can be configured as desired in order to obtain the desired image pattern as will be explained further below. In this example, the relief structure comprises a series of protrusions 6a periodically spaced around the surface of the cylinder 7 and hence in the machine direction MD.

As shown in Figures 1 and 3(c), as the relief structure 6 comes into contact with the resist layer 12, at least one of its protrusions 6a extends into the resist layer 12, preferably coming into contact with the underlying metal layer 11. The relative movement between the relief structure 6 and the substrate has the result that the inserted protrusion(s) 6a pushes resist material out of one or more corresponding regions of the substrate, resulting in gaps in the resist layer 12. As shown in Figure 3(c), the areas where the resist material remains become first pattern elements P₁ and the regions from which the resist material has been removed become second pattern elements P₂. The substrate continues along the transport path such that it is separated from the relief structure, resulting in the substrate carrying a patterned resist layer 12 formed of first elements P₁ where the resist is still present, and intervening second elements P₂ where the resist material is now substantially absent.

The substrate is then conveyed to an etching station 9 at which one or more etchant substances are applied to the substrate. The etchant substance(s) dissolve the exposed portions of the metal layer 11 in the second pattern elements P₂ whilst the resist material 12 protects the metal layer 11 in the first pattern elements P₁. The particular etchant selected will depend on the metal to be etched. For instance where the metal is aluminium or an alloy thereof, the etchant is preferably alkaline, such as sodium hydroxide. Where the metal is copper or an alloy thereof, the etchant is preferably acidic, such as hydrochloric acid. The etchant can be applied to the substrate by passing the substrate through an etchant bath, or spraying the etchant onto the substrate, for example. The result, shown in Figure 3(e), is an image pattern P formed in the metal layer 11, of first elements P₁ where the metal remains present, and intervening second elements P₂ where the metal is substantially absent.

It should be noted that, in the above method, the aim is not to replicate the contours of the relief structure 6 in the resist layer 12. Rather, the protrusions 6a expel the resist material out of regions of the substrate area, pushing the material into neighbouring areas (corresponding to troughs 6b) and/or off the substrate. Preferably, the protrusions act as blades, wiping the metal layer substantially clean of resist material in those regions. As described further below, the expelled resist material could, in some cases, fill the troughs 6b in which case the patterned resist layer 12 may take on the contours of the relief structure 6 to some extent. However generally the relative movement between the two components will mean that any such replication is inexact and typically the resulting profile of the resist layer 12 will be different from (the mirror image of) the relief structure 6.

Examples of suitable resist materials 12 which can be used in the above process include inks based on polymeric binders, and resins such as novolak resin. One exemplary resin that may be used is VMCA from UCAR which is a vinyl acetate/vinyl chloride copolymer. What is important is that the resist material is sufficiently deformable so as to allow patterning by the relief structure whilst exhibiting low inherent spreading so that the desired pattern will be retained in the resist layer during etching. This could be achieved for example by applying the resist material 12 as a solution which gradually dries throughout the process, such that only solids remain after patterning, thereby arresting any spreading of the resist. In another example, the resist material could be heated (or reheated) just before or as it comes into contact with the relief structure in order to increase its deformability, and then cooled while in contact with the relief structure and/or after separation in order to re-harden the material and fix its shape. For instance, where the resist material is a thermoplastic resin (for example VMCA from UCAR which as mentioned above is a vinyl acetate/vinyl chloride copolymer), this could be applied to the metal layer as a solution (i.e. dissolved in a solvent) or alternatively in a melted state. After the resist layer has been formed, the resin can then be heated (e.g. to approximately 120 degrees) prior to coming into contact with the relief cylinder, so that the material is deformable as the resin comes into contact with the relief structure. During patterning a pressure of around 5 bar may be applied between the relief cylinder and the substrate. The resin is then cooled quickly to fix the pattern and prevent spreading, which can be achieved by arranging the relief structure on a chiller roller/cylinder. It can then subsequently go on to be etched as described above.

However, it is more preferable to use a resist material 12 which is curable ― that is, upon appropriate treatment the resist material undergoes a chemical reaction which causes it to harden and become more solid. Typically this involves the formation of cross-links between polymer chains. The curable resist material 12 could be a radiation-curable resist material (e.g. UV-curable), or could be heat-curable (or a combination of both). Radiation-curable materials are particularly preferred due to the fast speed with which curing can be achieved. An example of a heat-curable resist material is a polyester polyol binder such as Stepanol PC-020-01 from Alfa Chemicals alongside N75 isocyanate cross linker. An example of a suitable UV-curable resist material is Lumogen OVD Primer from BASF. More generally, two examples of acrylate compounds commonly used in photocurable polymerisation are tripropylene glycol diacrylate (TPGDA) and dipentaerythritol hexaacrylate (DPHA). Upon reaction with an excited species each of the terminal double bonds in these acrylate compounds is able to be broken and can thus form a bond with other similar compounds to create a cross-linked network. TPGDA is classed as a difunctional monomer, exhibits low viscosity and offers a high reactivity. DPHA can be seen to be a hexafunctional monomer. Multifunctional monomers generally exhibit excellent reactivity and high cross-link density.

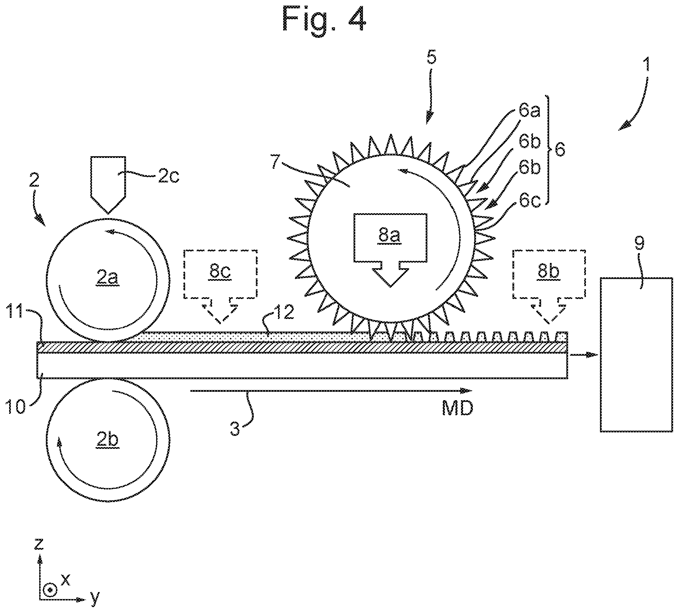

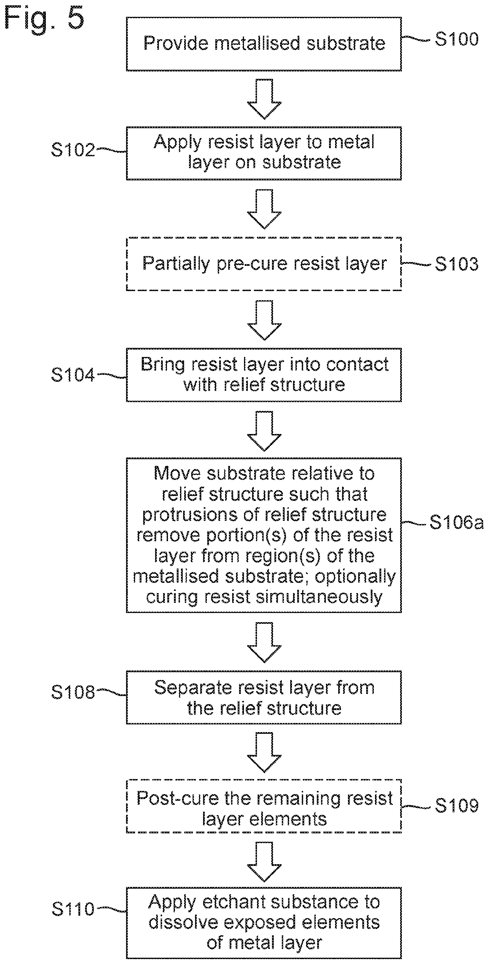

A second embodiment of the invention in which such a curable resist material is used will now be described with reference to Figures 4 and 5. The appearance of the substrate at the various stages of processing is much the same as in the first embodiment and so Figures 4 and 5 can also be read in conjunction with Figure 3. Figures 4 and 5 use like reference numerals for items already described in the preceding embodiment. Components shown in dashed lines in Figure 4 are optional, as are steps shown in dashed lines in Figure 5.

Thus, the exemplary apparatus 1 used to perform the method of the second embodiment, shown in Figure 4, is the same as that of Figure 1 save for the features which will now be described. The resist material applied at application 2 (step S102) is a curable resist material and is applied to the metal layer 11 in its uncured state, such that the so-formed resist layer 12 is a fluid or deformable solid. The resist layer 12 is then brought into contact with the relief structure 6 in the same manner as described previously (step S104). During patterning (i.e. whilst the resist layer 12 and the relief structure are in contact) in step S106a, the resist layer 12 is exposed to energy from a curing source 8a, such as radiation or heat ― most preferably UV radiation. For example, the cylinder 7 and at least part of the relief structure may be transparent to the curing radiation so that the curing source 8a may be located inside the cylinder 7. Hence, the resist layer is caused to harden such that, once patterned, any lateral spreading of the material is reduced or, preferably, eliminated.

As an alternative or in addition to curing the resist material during patterning by curing source 8a, the resist material could be cured after patterning, i.e. after separation of the resist material from the relief structure (step S109, "post-curing"). Figure 4 illustrates a curing source 8b which may be provided for this purpose. For instance, it may be desirable to use curing source 8a to partially cure the resist material 12 such that it is near-solid at the point of separation but the cure is incomplete. This assists in the removal of the protrusions 6a from the resist material since adhesion of one to the other can be reduced or avoided. The resist material can then be fully cured by post-curing source 8b.

It may also (or alternatively) be desirable to perform a partial pre-cure of the resist material 12 after it has been applied to the metal layer 11 and before patterning takes place. Whatever type of resist material is used, the present inventors have found that the results of patterning are improved by the use of a thin resist layer 12, and in particular one with a thickness less than the height of the protrusions 6a of the relief structure 6. For instance, particularly good results have been achieved where the thickness of the applied resist layer is of the order of 1 to 2 microns, or 2 gsm. This will be described in further detail below but for the time being it is sufficient to note that the use of a curable resist material can assist in enabling the provision of a thin resist layer 12 since the material can be applied in a highly fluid, low viscosity form at application station 2c. This promotes spreading of the material over the area of the substrate 10 and hence helps to achieve a thinner resist layer 12. However, patterning of such a low viscosity resist material will be difficult due to the spreading and so preferably the viscosity of the resist material may be increased prior to patterning, by partially pre-curing the resist material (step S103). Figure 4 shows a pre-curing source 8c provided for this purpose. Of course, the pre-cure must not be complete since the resist material should still be sufficiently deformable for patterning in the manner described above.

It should be noted that whilst the various curing sources 8a, 8b and 8c may preferably be of the same type (e.g. all UV radiation sources) this is not essential. In other cases the curable resist material could contain more than one different types of initiator, such as a heat-activated initiator in addition to a radiation-sensitive initiator. Hence the pre-curing source 8c could for instance be a heat source, activating the thermal initiator to achieve a first part of the cure, and then curing sources 8a and/or 8b (whichever is/are provided) could comprise radiation sources to initiate the photosensitive initiator and complete the cure.

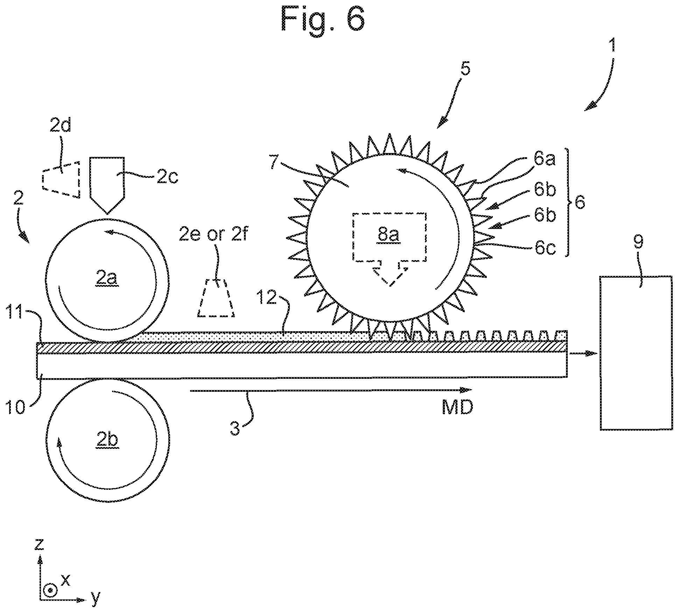

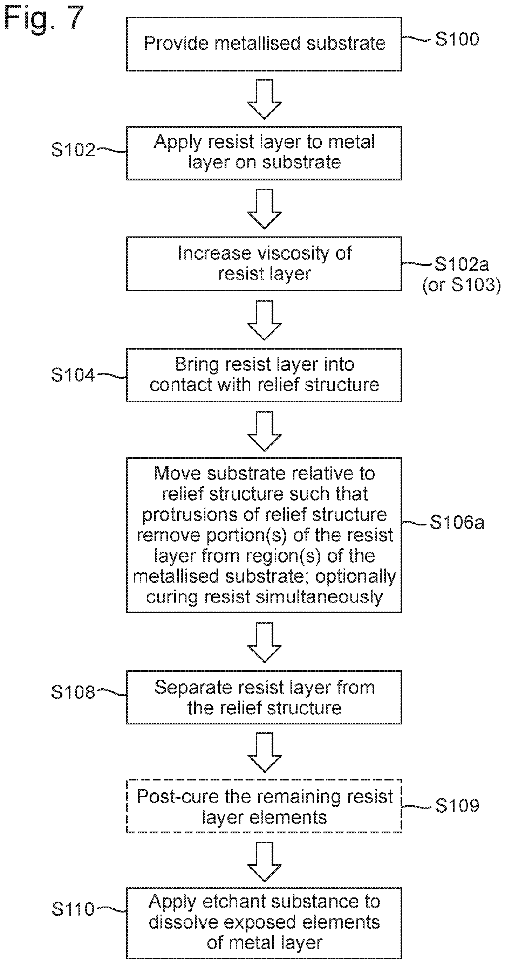

As just mentioned, it is desirable to apply the resist material to the substrate at a relatively low viscosity and then increase its viscosity prior to patterning. One way to achieve this is by partial pre-curing as illustrated above. Alternative techniques will now be illustrated with reference to Figures 6 and 7, which relate to a third embodiment of the invention. The appearance of the substrate at the various stages of processing is much the same as in the first and second embodiments and so Figures 6 and 7 can also be read in conjunction with Figure 3. Figures 6 and 7 use like reference numerals for items already described in the preceding embodiments. Components shown in dashed lines in Figure 6 are optional, as are steps shown in dashed lines in Figure 7. The exemplary apparatus 1 used to perform the method of the third embodiment, shown in Figure 6, is the same as that of Figure 1 save for the features which will now be described.

Whether or not the resist material is a curable resist material, it may preferably be applied in the form of a solution, the solid components of the resist material being dispersed in a suitable solvent. In this way the viscosity of the fluid at the point of application will depend (at least in part) on the proportion of solid components to solvent and this can be adjusted as desired to achieve the required resist layer thickness. Once applied to the metal layer 11, the viscosity of the resist layer 12 is increased (step S102a) by either active or passive drying of the resist material to evaporate some or all of the solvent. This can be promoted by the provision of a heater 2e, such as an oven through which the substrate is conveyed. This approach can be used in conjunction with a curable resist material, such as a UV curable material, the drying of step S102a being used either in addition to or instead of the pre-curing step S103 described above. For instance, the present inventors have found that particularly good results can be achieved using this approach with a resist material composition comprising a mixture of the following components:
1 gram - Lumogen OVD Primer 301 from BASF;
0.01 gram - Surfactant (such as BYK-020 or BYK-055); and
0.2 gram ― vinyl acetate / vinyl chloride ―based resist (to promote substrate adhesion).

The above composition was diluted with MEK (methyl ethyl ketone) to yield a 10% solids solution for application to metal layer 11. The solution had a viscosity of around 43 mPa.s (measured using zahn cup or cone and plate rheometer (22 degrees C)) and was found to spread easily and quickly so as to form a thin resist layer 12. The MEK solvent was then dried off (e.g. using an oven at about 80 degrees C for 1 to 2 seconds), leaving a very thin layer of pure, curable resist material.

In another alternative, the resist material may be heated to reduce its viscosity prior to application to the substrate 10 (evidently this option is not suitable for a thermally-curable resist material). In this case, a heater 2d may be provided to heat the resist material in reservoir 2c (or on roller 2a) as it is applied to the substrate. Once the resist layer 12 has been formed, the viscosity of the material can be increased by cooling the substrate. Again this may be passive or active, and in the latter case a cooling module 2f may be provided, such as a refrigerator or a coolant spray.

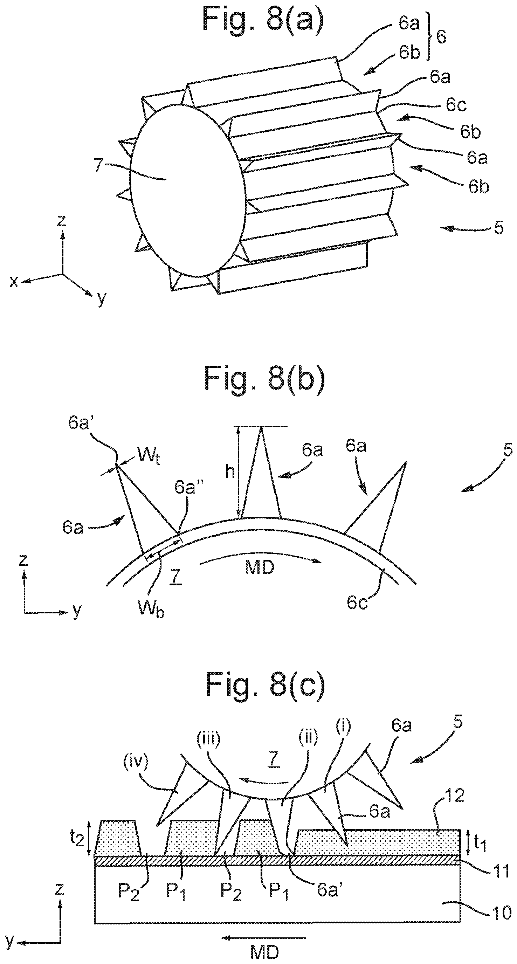

The manner in which the resist material 12 is patterned by the relief structure 6 will now be described in more detail with reference to Figures 8 to 12. Figure 8(a) shows an exemplary relief structure 6 having much the same form as that referred to above in connection with the first, second and third embodiments, arranged on the circumferential surface of a cylinder 7. The relief structure 6 comprises a plurality of protrusions 6a which extend away from a support 6c, which here corresponds to the cylinder surface. In this example, the protrusions 6a are spaced from one another at their bases, but this is not essential. Either way, troughs 6b will be defined between adjacent protrusions 6a.

As explained above, the protrusions act to expel resist material from certain regions of the substrate during relative motion in the machine direction (MD) between the substrate and the relief structure. Each protrusion preferably acts as a blade, wiping the surface of metal layer 11 clean of resist material in these regions. To improve the precision with which these regions are formed, it is desirable that when the relief structure comes into contact with the resist layer, the protrusions cut through the resist material cleanly upon insertion (to avoid compression of the material between the protrusion and the substrate which could lead to spreading). As such it is preferable for each protrusion to have a sharp tip, and most preferably a tip which is narrower than the base of the protrusion. This is shown more clearly in Figure 8(b) which is a cross-section through three of the protrusions 6a of the relief structure 6 shown in Figure 8(a), all of which are identical in this example. Thus, each protrusion 6a has a substantially triangular cross-section with a tip 6a' which has a width Wₜ that is narrower than the width W_{b} at the base 6a" of the protrusion. The height h of the protrusion 6a is measured between its tip 6a' and base 6a" in the direction normal to the support surface 6c (which here is a radius of the cylinder 7). In this example each protrusion extends laterally in a straight line along the length of the cylinder so as to form a prism. The side faces of each prism are straight, intersecting at the tips 6a' to provide a sharp edge for cleanly cutting through the resist material as already described. In alternative embodiments the cross-sections of the protrusions need not be triangular. For instance the main part of each protrusion could be parallel-sided, but preferably a sharp tip with angled sides is still provide at the distal end. Nonetheless, a wider base as provided by a triangular cross section is beneficial for improved durability and hence longevity of the relief structure.

The relief structure could be made of any material such as polymer, ceramic, glass or metal. However, it is particularly preferred that at least the tips of the protrusions 6a, and preferably the whole of each protrusion, is made of a flexible material such as an elastomeric polymer, such that when the protrusions contact the metal layer 11 on substrate 10, there is deformation of the protrusion tip 6a'. For instance, materials with a typical shore hardness of 40 to 70 on the A scale are preferred. Thus, the whole relief structure could for example be moulded in a flexible material or each protrusion could be formed of a first body portion of a relatively inflexible material and a second tip portion of a relatively flexible material. Such flexing of the protrusion tips against the metallised substrate can be used by itself to give rise to the necessary relative movement between the tips of the relief structure and the substrate, or in combination with conveying the relief structure and substrate at different relative speeds.

In addition, especially if a radiation-curable resist material is to be used, it is preferable that at least part of the relief structure 6 is formed of a material which is transparent at least to the radiation wavelength(s) in question, e.g. UV. At least the support 6c should be transparent since as shown below it is the troughs 6b where the resist material needs to be cured and hence if the protrusions are spaced it may be adequate if the radiation reaches the resist material through the support 6c only. However, more preferably the protrusions 6a are also formed of such a transparent material. In particularly preferred examples the relief structure 6 is formed of an optically transparent elastomer such as PDMS (polydimethylsiloxane), or a silicone material. These are polymer materials with a low Young's modulus. A master mold can be made using conventional patterning techniques and the soft relief structure material is able to replicate the negative of the master. Some additional advantages of using a soft, i.e. flexible, material for the relief structure 6 are listed below:
- The flexibility of the relief structure allows it conform to non-flat substrates (for example curved, warped or bowed surfaces).
- Cost reduction, as soft relief structures are less expensive to make, and one can produce many inexpensive soft molds from one expensive master.
- Since the relief structure can deform around any contaminant particles, the structure becomes much less sensitive to these, thus prolonging the structure's life.
- Flexible relief structure materials generally have a low surface energy. This stops the resist adhering to the relief structures instead of adhering to the substrate.

Figure 8(c) shows the relief structure 6 in contact with an exemplary substrate carrying resist layer 12 during patterning. In this example, the cylinder 7 and the substrate 10 are both conveyed in the same machine direction MD with the same speed as one another. As the substrate advances, a protrusion 6a makes contact and cuts into the resist layer 12 (illustrated by the protrusion labelled (i)). As the movement continues, the protrusion extends through the full thickness of the resist layer 12 and contacts the metal layer 11. Preferably the pressure applied between the relief structure 6 and the substrate 10 is such that the tip of the protrusion 6a becomes pressed against the metal layer 11 and, still preferably, is deformed against the surface as shown by protrusion (ii). For instance the tip 6a' may become flexed against the metal surface, as shown, or may become spread out against the surface. The flexing of the protrusion amounts to relative movement between the protrusion tip and the metal surface as the tip effectively slides across the metal surface under the transverse pressure applied between the cylinder 7 and the substrate 10 in order to adopt its flexed profile. The deformation of the protrusion 6a against the metal surface (and hence close contact between the two components) also helps to ensure that the resist material is more completely removed from the metal. As it flexes, the protrusion pushes the resist material out of a region of the substrate and into a neighbouring area.

As the substrate continues, the protrusion 6a is released from compression against the metal layer 11 (see protrusion (iii)), having expelled the resist material from a region P₂ of the substrate. The length of region P₂ in the machine direction will depend on a number of factors including the speed of relative movement and the applied pressure. Eventually, the protrusion lifts out of the resist layer (see protrusion (iv)), leaving a pattern of elements P₁ where the resist material remains present, and intervening elements P₂ where the resist material is absent, corresponding to the regions from which it has been expelled by the relief structure 6.

It should be noted that in a variant of this embodiment the degree of relative movement between the relief structure tips 6a' and the substrate could be adjusted by additionally conveying the relief cylinder 7 and the substrate 10 at different relative speeds from one another (as in the first embodiment).

It will be appreciated that to achieve full removal of resist material from the regions, the tips of the protrusions preferably make good contact with the metal layer. It is therefore desirable that the resist layer 12 be applied to the metal layer 11 at a thickness t₁ less than the height h of the protrusions, as mentioned above. For instance, particularly good results have been achieved where the thickness of the applied resist layer is of the order of 1 to 2 microns, or 2 gsm, with a protrusion height of around 6 microns. This not only avoids the resist layer spacing the relief structure too far from the substrate, but also reduces the volume of expelled resist material that will be pushed off the substrate area during patterning. As shown in Figure 8(c), as each region is cleared of resist material, it is pushed into the neighbouring area corresponding to a trough of the relief structure and if this has sufficient empty volume, the thickness of the resist layer can be increased to t₂ in these areas. This improves the effectiveness of the resist material remaining in elements P₁ during later etching.

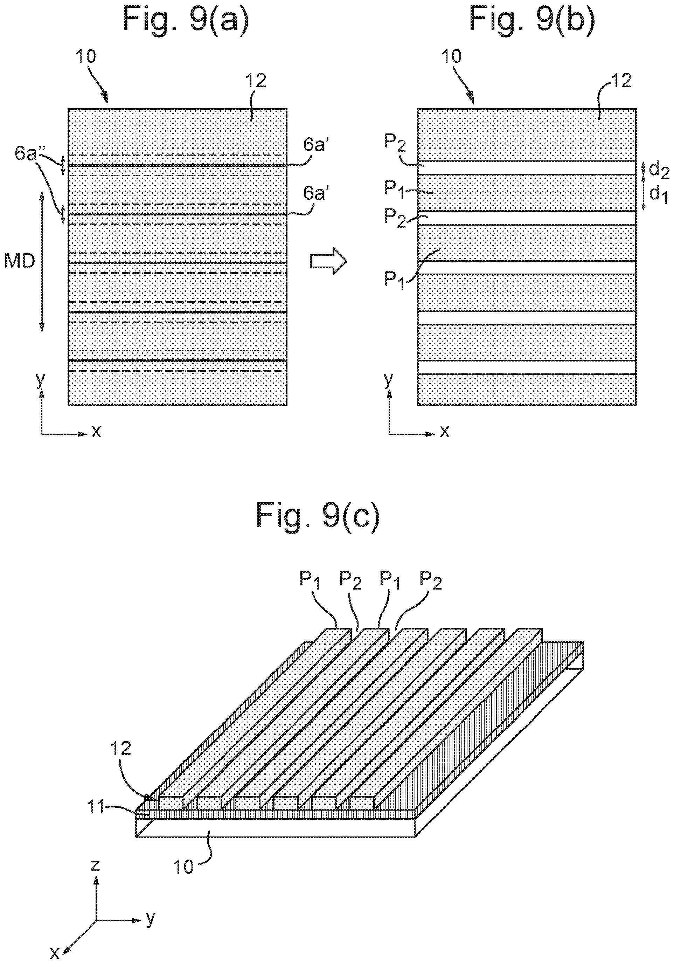

Figure 9 illustrates an exemplary substrate subjected to the same patterning procedure as shown in Figure 8. Figures 9(a) and (b) show the same substrate in plan view before and after patterning, respectively, while Figure 9(c) shows the patterned substrate in perspective view. In Figure 9(a), the solid lines marked 6a' represent the positions where the tips of the protrusions 6a make contact with the metal layer 11 although it will be appreciated that in practice this will not usually happen simultaneously but rather one at a time. The dashed lines on either side represent the base 6a" of each protrusion 6a. Thus, the protrusions represented in Figure 9(a) are straight, parallel triangular prims as shown previously in perspective view in Figure 8(a). Figure 9(b) shows the same substrate after the relative motion (along machine direction MD) has been completed and the relief structure separated from the resist 12. It will be seen that each protrusion 6a has cleared the resist material from a corresponding region P₂ leaving the resist material confined to intervening areas P₁. The same result is shown in perspective view in Figure 9(c). The width of each first pattern element, d₁, and that of each second pattern element, d₂, will depend on factors such as the relative speed of motion during patterning and the pressure applied, as well as the relief structure itself but preferably these dimensions are of the order of 100 microns or less, more preferably 50 microns or less, most preferably 20 microns or less. In tests, the inventors have achieved line widths of 5 to 6 microns.

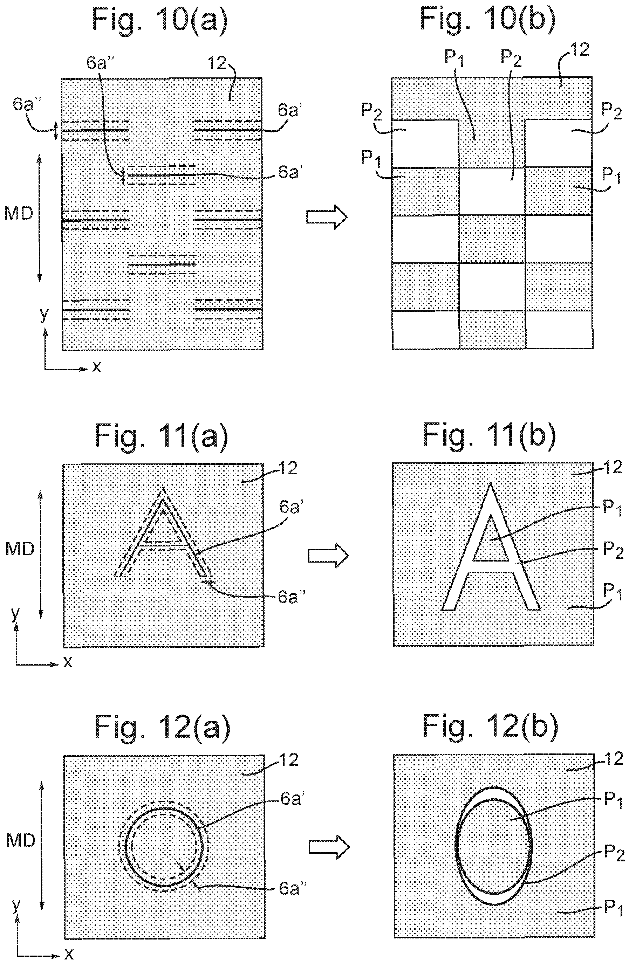

The formation of line patterns such as that illustrated above finds many applications such as in the construction of lenticular devices, venetian blind devices and moire interference devices as will be exemplified below. However, the presently disclosed methods can be used to form any desired image pattern through design of the relief structure and control of the processing parameters, and some further examples are shown in Figures 10, 11 and 12. In each case, Figure (a) shows the substrate prior to patterning, the relief structure being illustrated by solid and dashed lines in the manner already explained with reference to Figure 9(a), and Figure (b) shows the patterned substrate.

In Figure 10, the relief structure 6 comprises an array of straight prism segments arranged in an alternating manner. The result of relative movement in the machine direction MD is a "checkerboard" arrangement of first and second pattern elements P₁, P₂. Such arrangements find particular utility in two-dimensional lenticular devices, for example.

In Figure 11, the relief structure 6 defines a microimage in the form of an alphanumerical character, here the letter "A". In practice the relief structure may comprise a plurality of identical microimages arranged to form a regular orthogonal or hexagonal array, but only one is depicted here for clarity. After relative movement between the relief structure 6 and the resist material 12, a resist-free region P₂ having the shape of a letter "A" is formed on the substrate, however, this is elongated in the machine direction relative to the original form of the letter on the relief structure. This is due to the movement of the relief structure through the resist material. It will be noted that all parts of the letter "A" have a component of their direction in the direction orthogonal to the machine direction MD, with the result that all parts of the letter are transferred to the substrate pattern.

Figure 12 shows another example where this is not the case. Here the relief structure 6 defines the letter "O" (again, it may in fact carry an array of these microimages). Now, after relative movement, the resist has a resist-free region P₂ again in the shape of an elongated "O" but its two sets of opposing sides are different in line width. This is because those portions of the relief structure running approximately parallel to the machine direction MD do not present a surface which can push resist material out of the region during the relative movement. In contrast, those portions running in the orthogonal direction are able to engage with the resist material in the manner described previously and clear the respective regions of the substrate.

For the above reason, in general terms it is preferred that the relief structure includes at least some portions that have a component of their direction in the direction orthogonal to the machine direction. In other words, the entire protrusion should not lie parallel to the machine direction (although some parts of it may).

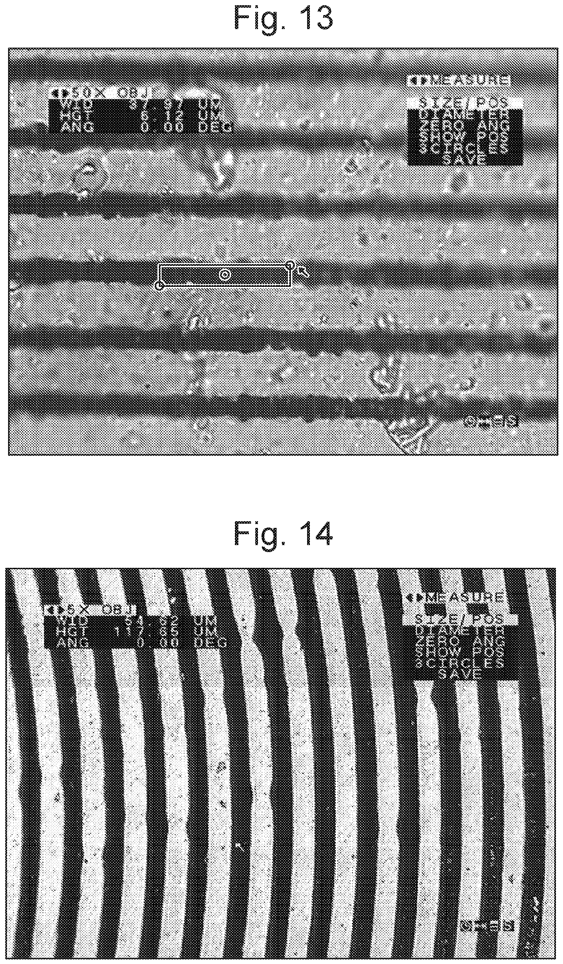

Figures 13 and 14 are photographs showing two exemplary image patterns formed using methods in line with those described above. Both photographs are transmission views with the metallised areas (elements P₁) appearing dark and the demetallised areas (elements P₂) appearing light. In Figure 13, an array of straight lines has been formed using a relief structure corresponding to that of Figures 8(a) and 9(a). The pitch between the protrusion tips was 20 microns. Metallised lines of between 5 and 6 microns have been achieved. In Figure 14, an array of curved lines has been formed using a different relief structure in which the protrusions follow corresponding curved lines extending generally in the direction orthogonal to the machine direction MD. Here, the pitch between the protrusion tips was about 120 microns. Metallised lines of about 54 microns have been achieved.

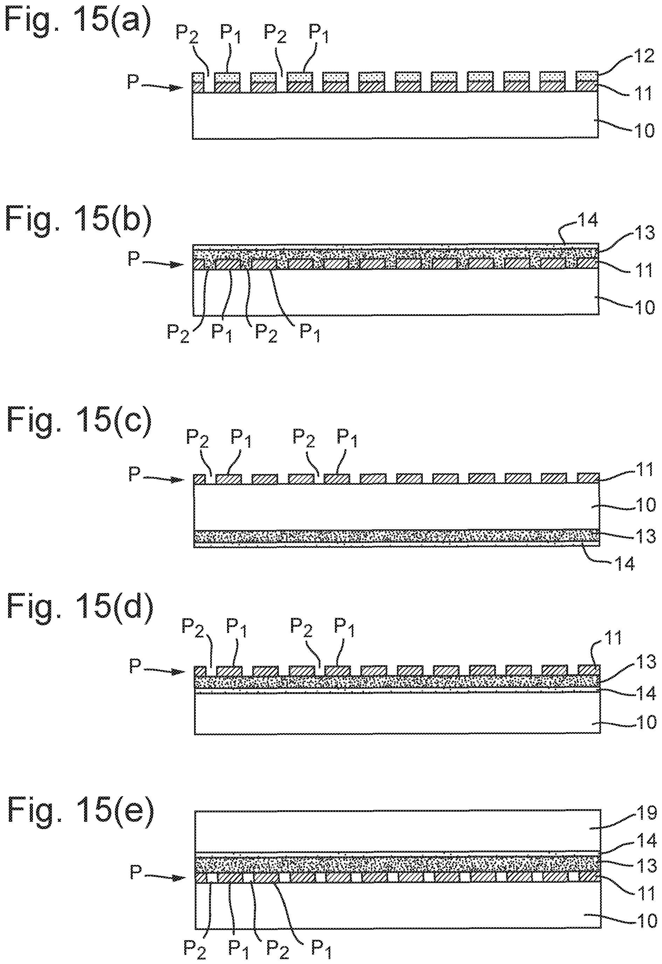

Various further optional features of the method will now be described. Figures 15(a) to (e) show cross-sections through different substrates carrying image patterns formed according to different embodiments of the invention. Figure 15(a) is identical to Figure 3(e) and shows the substrate after etching (step S110), as previously discussed. Here the resist layer 12 is shown to remain in place in the first pattern elements 12 and this can be particularly desirable if the resist material is optically detectable, e.g. carrying a coloured tint or a luminescent substance. In still further cases the remaining resist 12 could have different optical characteristics in different areas of the substrate, e.g. different colours, so as to define a large-scale macro pattern or image. This could be achieved by patterning gravure roller 2a and providing multiple application stations 2, one for each resist material.

However in other embodiments it is preferred to remove the remaining resist material 12 once etching step S110 has been completed and this can be achieved by carrying out a further etching step using a different etchant which dissolves the resist but not the metal layer 11. In this case (and if the resist 12 remains but is transparent or single-coloured) the first pattern elements P₁ will all have the same appearance (corresponding to that of metal layer 11), and the second pattern elements P₂ will be transparent. This may be desirable in some implementations of security devices. However in many cases it is preferable to modify the optical characteristics of the second pattern elements P₂ and this can be achieved, in one example, by applying a colour layer 13 over the patterned metal layer 11, as shown in Figure 15(b). The colour layer 13 comprises at least one optically detectable substance and is applied over at least a zone of the array. Whilst in preferred cases the colour layer will have a visible colour (i.e. visible to the naked eye), this is not essential since the at least one optically detectable substance could be, for example, a luminescent substance which emits outside the visible spectrum and is only detectable by machine. In general, the colour layer may comprise any of: one or more visible dyes or pigments; luminescent, phosphorescent or fluorescent substances; metallic pigments; interference layer structures or interference layer pigments (e.g. mica, pearlescent pigments, colour-shifting pigments etc.), for example. Substances such as these may be dispersed in a binder to form an ink, for example, suitable for application by printing or coating, or could be applied by other means such as vapour deposition. Most preferably the colour layer is applied by a printing technique such as: laser printing, inkjet printing, lithographic printing, gravure printing, flexographic printing, letterpress or dye diffusion thermal transfer printing. Since the high resolution detail of the image element array is provided by the metal layer 11, the colour layer 13 does not need to be applied using a high resolution process and can if desired be applied in more than one working. It should be noted that a colour layer 13 can also be applied over remaining elements of the resist layer 12 if these remain in place.

Since the colour layer 13 does not need to be applied at high resolution, it can be made relatively thick and therefore may possess sufficiently high optical density to produce a good quality image by itself. However, in some cases it is desirable to increase the optical density by applying a substantially opaque backing layer 14 over the colour layer 13 as depicted in Figure 15(b). The backing layer 14 most preferably comprises a further metal layer, e.g. of aluminium. The provision of a backing layer 14 reduces the amount of light transmitted through the device which could otherwise confuse the final image, thereby improving the visual appeal and (in the case of a metal backing layer) making the colour of the first pattern elements, provided by colour layer 13, more reflective and therefore more intense.

In still further embodiments the colour layer could be located differently within the device structure, provided that from one side of the structure both the metal pattern elements P₁ and the portions of the colour layer 13 in the second pattern elements P₂ can be seen alongside one another. Figures 15(c) and (d) show two further exemplary substrates with different structures to illustrate this.

In Figure 15(c) the patterned metal layer 11 has been formed on the first surface of a transparent substrate 10 using the same method as previously described. The colour layer 13 is provided on the second surface of the transparent substrate so that when the structure is viewed from the side of the metal layer 11, the colour layer is visible through the gaps in the first pattern elements. Optionally, a substantially opaque backing layer 14 may be provided over the colour layer 13 on the second surface of the substrate as previously described.

In Figure 15(d) the colour layer 13 is provided on the first surface of substrate 10 before the patterned metal layer 11 is formed on the same surface. That is, the colour layer 13 is disposed on the metallised substrate web between the substrate and the metal layer 11 provided in step S100 of the above-described method. A substantially opaque backing layer 14 may optionally also be provided under the colour layer 13 on the first surface, or on the second surface of the substrate 10 (not shown). In these embodiments, the substrate 10 need not be transparent since the image element array will not be viewed through it in the finished device.

Embodiments in which the demetallised pattern is formed on a substrate with a pre-existing colour layer 13 (whether located on the first or second surface of the substrate) are better adapted for use in circumstances where no registration is desired between the colour layer 13 and the demetallised pattern, since it is technically more straightforward to register the application of the colour layer 13 to an existing demetallised pattern than vice-versa.

In a still further embodiment, shown in Figure 15(e), in place of printing or coating the colour layer 13 onto substrate 10, the colour layer 13 (and optional backing layer 14) could also be formed on another substrate 19 and then laminated to or transferred onto the metal layer 11.

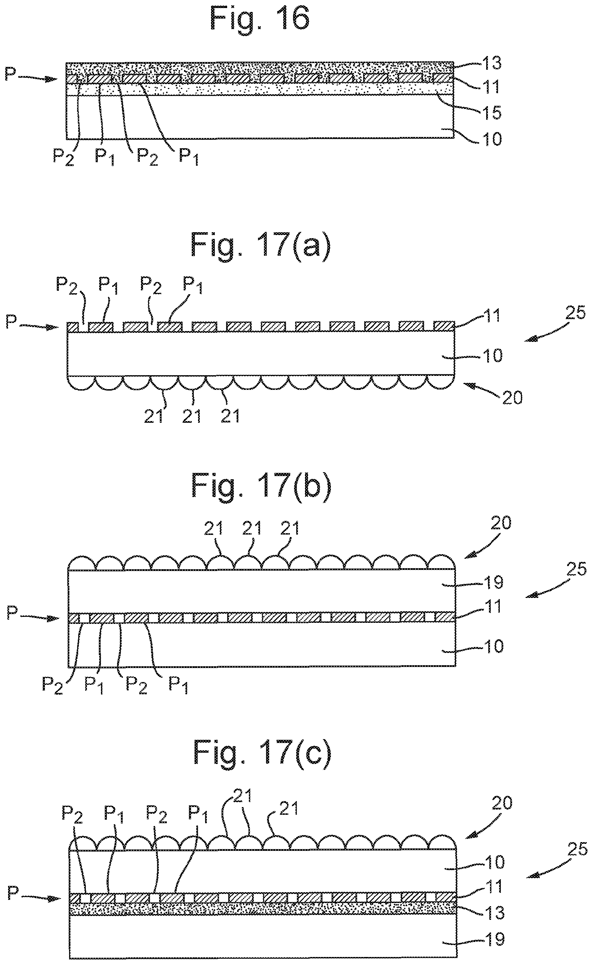

In many implementations, the uniformly metallic appearance of the first pattern elements P₁ will be desirable. However, the specularly reflective nature of the metal layer 11 can have the result that the appearance of the elements will depend significantly on the nature of illumination. As such in some embodiments it is preferred to reduce the degree of specular reflection by providing a filter layer 15 (Figure 16) in the form of a light diffusing layer which will ultimately sit between the metal layer and the viewer, acting to diffuse the light reflected by the metal pattern elements P₁ and hence improve the light source invariance of the finished device. The light diffusing layer 15 is located between the transparent substrate 10 and the metal layer 11 and may therefore be incorporated already in the metallised substrate web provided at the start of the method. Alternatively, if the metallisation is carried out as part of the method, the light diffusing layer 15 may be applied to the substrate in an earlier step. The light diffusing layer can comprise a scattering pigment dispersed in a binder and may be coloured or colourless. The layer can be applied by coating or printing, preferably flexographic, gravure, lithographic or digital printing, and may optionally be a radiation-curable material, e.g. requiring UV-curing. In some embodiments, the appearance of the light diffusing layer 15 may be uniform across the image element array. However in other cases the light diffusing layer could comprise multiple different materials arranged as a multi-coloured pattern or image. The light-diffusing layer need not be applied with high resolution and so can be formed of multiple workings if desired.

In still further embodiments, the filter layer 15 may not be light-diffusing (i.e. optically scattering), but may comprise a clear, coloured material which can be used to modify the appearance of the metal pattern elements. For example, by providing a filter layer 15 having an orange/brown tint in combination with a metal layer 11 of aluminium, the metal takes on the appearance of copper. The tinted filter layer 15 could be applied to selected regions only (optionally with a clear colourless layer in other areas) to give a bimetallic effect.

The filter layer 15 will typically not be soluble in the etchant used in step S110 and so will typically remain across the whole image array once the metal layer 11 has been patterned, as shown in Figure 16. If the filter layer is sufficiently translucent such that a contrast can still be observed between the first and second pattern elements P₁, P₂, this may be acceptable and the light diffusing layer may remain across both sets of elements in the final array. However, generally it is preferred to remove the filter layer 15 from the first pattern elements and this can be achieved by applying a suitable further etchant in which the filter is soluble. A colour layer 13 can then be applied if desired, followed by an optional backing layer 14 (both as described above).

Since the filter layer 15 is backed up by metal layer 11, it is not required to be of high optical density, although it should act to diffuse and/or to tint or selectively absorb and reflect different colours. Consequently the filter layer 15 can be made thin and this is preferred in order to minimise undercutting of the filter layer during etching. Preferably, the thickness of the filter layer 15 should be equal to or less than the minimum dimension (e.g. line width) of the pattern elements P₁, P₂, more preferably half that dimension or less. For example, if the pattern elements P₁ or P₂ have a dimension of 1 micron, the filter layer should preferably be no thicker than 1 micron, more preferably no thicker than 0.5 microns.

Like the (optional) filter layer 15, the colour layer 13 may have a uniform appearance across the array, or at least a zone of the array in which it is provided, in which case the finished image element array will be duotone (unless a multi-coloured light diffusing layer is provided). This will be desirable in certain types of security device. However, to increase the complexity and security level of the device, it is preferred that the colour layer 13 comprises multiple zones each comprising different optically detectable substances, e.g. being of different visible colours. The arrangement of different zones may be highly complex, e.g. representing a photograph, or may comprise a simpler arrangement of larger distinct zones. Preferably the colour layer 13 displays an image or indicia (e.g. letters, numbers or symbols) either through the relative arrangement of the zones and/or by the periphery of the whole colour layer (i.e. the combined periphery of the zones). In the ensuing examples, different zones of the colour layer 13 will be described for simplicity as having different "colours" but as noted above whilst in preferred cases these will be different visible colours, this is not essential as the optically detectable substances could be machine readable only. The term "colour" is also intended to include achromatic appearances such as black, grey, white, silver etc., as well as red, green, blue, cyan, magenta, yellow etc.

Figures 17(a), (b) and (c) illustrate three exemplary security devices which may be formed in accordance with embodiments of the invention. In each case an image pattern P is combined with a viewing component, here in the form of an array 20 of focussing elements 21 (such as lenses or mirrors), in such a way to give rise to an optically variable effect. For instance, the resulting devices may be moire magnification devices, integral imaging devices or lenticular devices of which examples will be given below. In the Figure 17(a) device, the image pattern P is formed on a first surface of transparent substrate 10 and the focussing element array 20 is provided on the second surface of the same substrate, e.g. by cast-curing, embossing or printing the focussing elements on with a doming resin. Alternatively, as shown in Figure 17(b) the focussing element array could be provided on a second transparent substrate 19 which is laminated to substrate 10 on which the image pattern P has been formed. If substrate 10 has been configured as a transfer film with a release layer between the substrate material 10 and the metal layer 11 (not shown), the substrate 10 could ultimately be discarded with the resulting device having much the same structure as that shown in Figure 17(a), with a single substrate 19 remaining.

Figure 17(c) shows another embodiment of a security device in which the image pattern P has been formed on the first surface of substrate 10 and the focussing elements 20 are provided on the other, as in Figure 17(a) and then the complete assembly has been laminated to a second substrate 19 carrying a colour layer 13 as described above. It is possible to incorporate focussing element arrays with the image patterns in many different ways. For example a focussing element array could be applied to any of the substrate surfaces shown in the embodiments of Figures 15(a) to (e), to thereby form a security device.

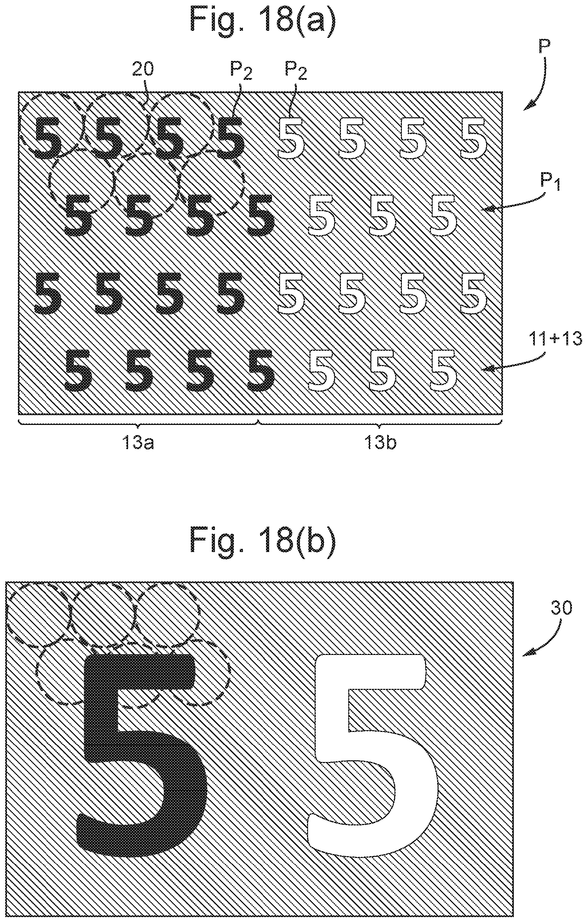

An embodiment of a security device will now be described with reference to Figures 18(a) and (b). In this case the security device is a moire magnifier, comprising an image element array P formed using the methods described above defining an array of microimages and an overlapping focussing element array 20 with a pitch or rotational mismatch as necessary to achieve the moire effect. Figure 8(a) depicts part of the image element array P as it would appear without the overlapping focusing element array, i.e. the non-magnified microimage array (but shown at a greatly increased scale for clarity). In contrast, Figure 18(b) depicts the appearance of the same portion of the completed security device, i.e. the magnified microimages, seen when viewed with the overlapping focussing element array, at one viewing angle.

In this example, the microimage array is formed using the methods described above and has a cross section corresponding substantially to that shown in Figure 17(c). Figure 18(a) shows the patterned metal layer 11 and underlying colour layer 13 in plan view and it will be seen that the second pattern elements P₂ form a regular array of microimages which here each convey the digit "5". In this case all of the microimages are of identical shape and size. The metallic first pattern elements P₁ form a contiguous, uniform background surrounding the microimages. Since the colour layer 13 here has two zones of different colour, the microimages in zone 13a appear in a first colour (here represented as black), whilst those in zone 13b appear in a second colour (here represented as white).

Figure 18(b) shows the completed security device 30, i.e. the image element array P shown in Figure 18(a) plus an overlapping focusing element array 20, from a first viewing angle which here is approximately normal to the plane of the device 30. It should be noted that the security device is depicted at the same scale as used in Figure 18(a): the apparent enlargement is the effect of the focusing element array 20 now included. The moire effect acts to magnify the microimage array such that magnified versions of the microimages are displayed. In this example just two of the magnified microimages are shown. In practice, the size of the enlarged images and their orientation relative to the device will depend on the degree of mismatch between the focussing element array. This will be fixed once the focusing element array is joined to the image element array. In this example, the first magnified microimage is formed from microimages all within zone 13a and hence appears black whilst the second magnified microimage is from microimages all within zone 13b and hence appears white. Upon tilting the magnified microimages may appear to change colour since their position relative to the device will change and they may cross into the other zone of colour layer 13.

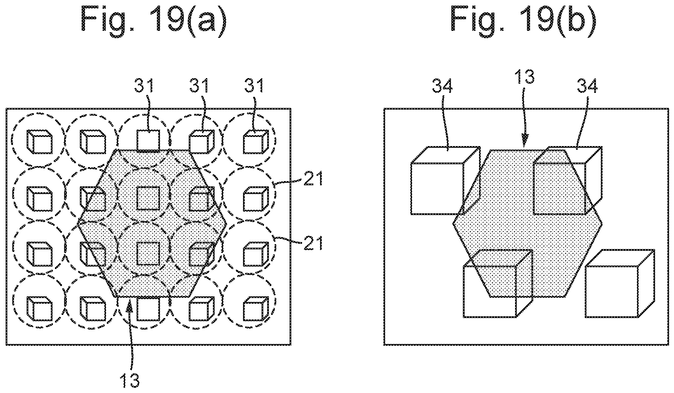

In the above example security device, the microimages are all identical to one another, such that the devices can be considered "pure" moire magnifiers. However, the same principles can be applied to "hybrid" moire magnifier / integral imaging devices, in which the microimages depict an object or scene from different viewpoints. Such microimages are considered substantially identical to one another for the purposes of the present invention. An example of such a device is shown schematically in Figure 19, where Figure 19(a) shows the unmagnified microimage array, without the effect of focusing elements 21, and Figure 19(b) shows the appearance of the finished device, i.e. the magnified image. As shown in Figure 19(a), the microimages 31 show an object, here a cube, from different angles. It should be noted that the microimages are formed as demetallised lines corresponding to the black lines of the cubes in the Figure, the remainder of the metal layer being opaque although this is shown in reverse in the Figure for clarity. A colour layer 13 is provided, here in the form of a single hexagonal zone, which provides colour to the demetallised lines and is concealed by the metal layer elsewhere. Outside the colour layer 13, the microimages may in practice not be visible due to a lack of contrast between the metal layer 11 and a backing layer 14 as previously mentioned. In the magnified image (Figure 19(b)), the moire effect generates magnified, 3D versions of the cube labelled 34. In reality, only those lines of the magnified cubes 34 which coincide with the colour layer 13 will be visible whilst those portions outside the coloured zone will be invisible or only weakly visible. As the device is tilted the magnified cubes 34 will appear to move across the device and so enter or leave the coloured zone 13 depending on their location and the degree of tilt. This gives the visual impression of the magnified images appearing and disappearing as they move across the central portion of the device. This, combined with the 3D appearance of the images, amounts to an effect with significant visual impact.

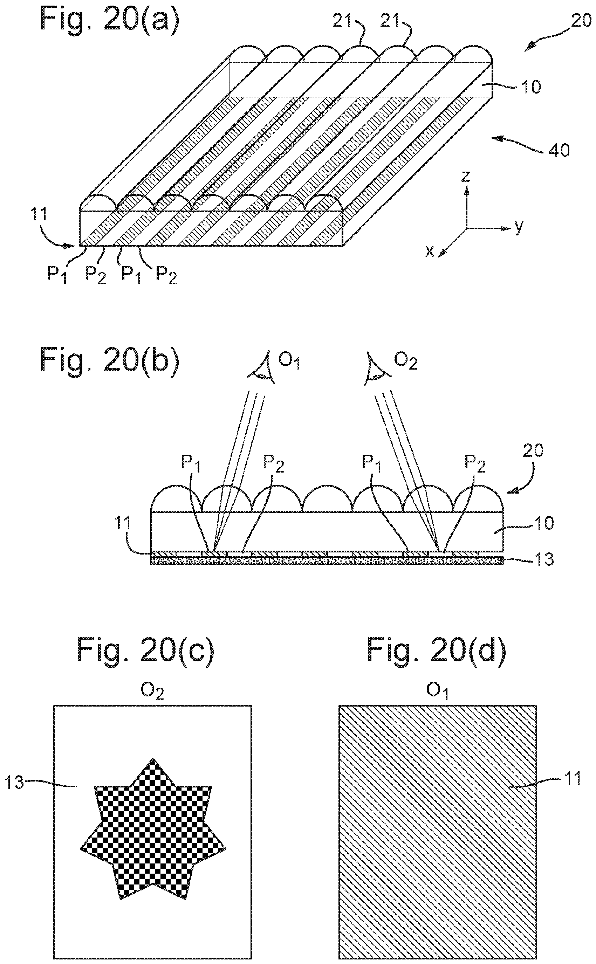

Figure 20 depicts a further embodiment of a security device 40, which here is a lenticular device. A transparent substrate 10 is provided on one surface with an array of focussing elements 20, here in the form of cylindrical lenses, and on the other surface with an image element array preferably formed of a patterned metal layer 11 and colour layer 13 as described above. The image array comprises first pattern elements P₁, and second pattern elements P₂. The size and shape of each first pattern element P₁ is substantially identical. The pattern elements in this example are elongate image strips and so the overall pattern of elements is a line pattern, the elongate direction of the lines lying substantially parallel to the axial direction of the focussing elements 20, which here is along the x-axis. The lateral extent of the pattern (including its elements P₁ and P₂) is referred to as the array area.

As shown best in the cross-section of Figure 20(b), the pattern formed in metal layer 11 and the focussing element array have substantially the same periodicity as one another in the y-axis direction, such that one first pattern element P₁ and one second pattern element P₂ lies under each lens 21. In this case, as is preferred, the width of each element P₁, P₂ is approximately half that of the lens pitch. Thus approximately 50% of the array area carries first pattern elements P₁ and the other 50% corresponds to second pattern elements P₂. In this example, the image array is registered to the lens array 20 in the y-axis direction (i.e. in the arrays' direction of periodicity) such that a first pattern element P₁ lies under the left half of each lens and a second pattern element P₂ lies under the right half. However, registration between the lens array 43 and the image array in the periodic dimension is not essential.

The colour layer 13 can take any form, including that of a complex, multi-coloured image such as a photograph.

When the device is viewed by a first observer O₁ from a first viewing angle, each lens 21 will direct light from its underlying first pattern element P₁ to the observer, with the result that the device as a whole appears uniformly metallic as shown in Figure 20(d). This is referred to more generally as (first) image I₁ since in other examples if a patterned light-diffusing layer were provided over the metal layer (as described in previous embodiments), the first pattern elements P₁ may collectively display any image according to that provided by the light-diffusing layer. When the device is tilted so that it is viewed by second observer O₂ from a second viewing angle, now each lens 21 directs light from the second pattern elements P₂ to the observer. As such the whole device will now appear to display the appearance of the colour layer 13, which in this case carries a star shaped image as shown in Figure 20(c) which constitutes a (second) image I₂. Hence, as the security device is tilted back and forth between the positions of observer O₁ and observer O₂, the appearance of the device switches between image I₁ and image I₂.

In order to achieve an acceptably low thickness of the security device (e.g. around 70 microns or less where the device is to be formed on a transparent document substrate, such as a polymer banknote, or around 40 microns or less where the device is to be formed on a thread, foil or patch), the pitch of the lenses must also be around the same order of magnitude (e.g. 70 microns or 40 microns). Therefore the width of the pattern elements is preferably no more than half such dimensions, e.g. 35 microns or less.

Two-dimensional lenticular devices can also be formed, in which the optically variable effect is displayed as the device is tilted in either of two directions, preferably orthogonal directions. Examples of patterns suitable for forming image arrays for such devices include forming the first pattern elements P₁ as grid patterns of "dots", with periodicity in more than one dimension, e.g. arranged on a hexagonal or orthogonal grid. For instance, the first pattern elements P₁ may be square and arranged on an orthogonal grid to form a "checkerboard" pattern with resulting square second pattern elements P₂ in which the colour layer 13 is visible (as shown in Figure 10 for example). The focusing elements in this case will be spherical or aspherical, and arranged on a corresponding orthogonal grid, registered to the image array in terms of orientation but not necessarily in terms of translational position along the x or y- axes. If the pitch of the focussing elements is the same as that of the image array in both the x and y directions, the footprint of one focussing element will contain a 2 by 2 array of pattern elements. From an off-axis starting position, as the device is tilted leftright, the displayed image will switch as the different pattern elements are directed to the viewer, and likewise the same switch will be exhibited as the device is tilted up-down. If the pitch of the focusing elements is twice that of the image array, the image will switch multiple times as the device is tilted in any one direction.

Similar effects can be achieved with other two dimensional arrays of pattern elements, e.g. using second pattern elements P₂ which are circular rather than square. Any other "dot" shape could alternatively be used, e.g. polygonal.

Lenticular devices can also be formed in which the two or more images (or "channels") displayed by the device at different angles do not correspond exclusively to the first pattern elements on one hand and the second pattern elements on the other. Rather, both pattern elements are used in combination to define sections of two or more images, interleaved with one another in a periodic manner. Thus, in an example the first pattern elements may correspond to the black portions of a first image and those of a second image, whilst the second pattern elements may provide the white portions of the same images, or vice versa. Of course the images need not be black and white but could be defined by any other pair of colours with sufficient contrast. Sections of the first and second images are interleaved with one another in a manner akin to the pattern of lines shown in Figure 20. When the device is tilted the two images will be displayed over different ranges of angles giving rise to a switching effect. More than two images could be interleaved in this way in order to achieve a wide range of animation, morphing, zooming effects etc. In embodiments such as these the colour layer 13 preferably has a uniform appearance (e.g. single colour) across the array as does any light-diffusion layer provided resulting in a duo-tone appearance.

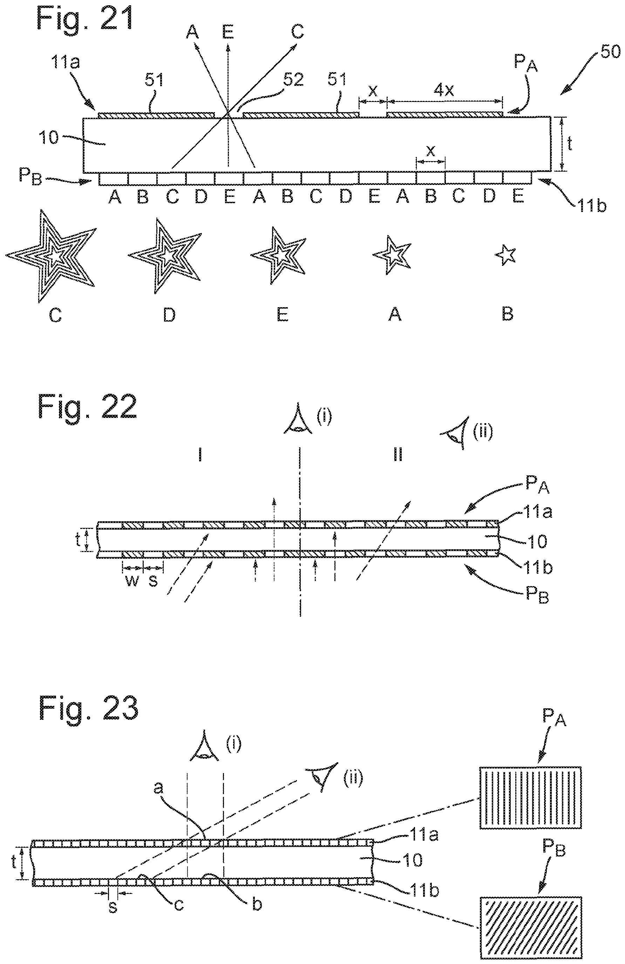

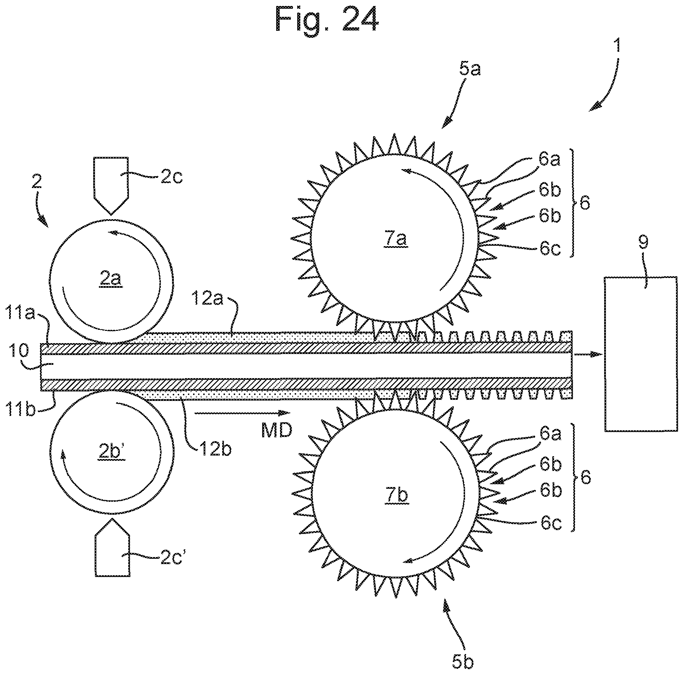

In all of the above examples of security devices, a focusing element array is employed to co-operate with the image element array to generate an optically variable effect. However, this is not essential and Figures 21, 22 and 23 show some examples of security devices with image element arrays made using the above described methods which do not require focussing element arrays. In these examples, two image element arrays are manufactured using the above-described methods, one on each surface of the substrate material 10, as will be described further below with reference to Figure 24. However in each case it will be appreciated that just one or other of the described image arrays 11a, 11b need be formed using this technique and the other could be formed using any other available method, e.g. printing.

Figure 21 shows a security device 50 which operates on similar principles to those of the lenticular device described above with respect to Figure 20, but utilising two demetallised image element arrays 11a, 11b rather than a single image element array combined with a focusing element array. In this case, one image element array 11a formed on a first surface of transparent substrate 10 forms a masking grid of metal lines 51 spaced by gaps 52, whilst the other image element array 11b formed on the second surface of transparent substrate 10 exhibits a pattern comprising a sequence of image components, labelled A, B, C, etc. Each of the complete images A, B, C, etc from which the image elements are taken is shown under the cross-section of the device and it will be seen that these comprise a sequence of animation steps depicting a star symbol changing in size. To create the pattern formed in metal layer 11b, the five images A to E are split into elements or "slices" and interleaved with one another so that a slice of image A is positioned next to a slice of image B, which in turn is positioned next to a slice of image C, and so forth. The resulting pattern is formed as a relief structure 6 and transferred to a resist layer 12 on metal layer 11b in the manner described above, before etching as appropriate. On the opposite side of transparent substrate 10, a masking grid is formed by patterning metal layer 11a using the same method via a different relief structure 6 resulting in a spaced array of visually opaque lines 51 with intervening transparent portions 52 through which the pattern in metal layer 11b may be viewed.

The device could be designed to be viewed in reflected or transmitted light. Transmitted light is preferred since the contrast in the image can generally be perceived more clearly and in addition the same visual effect can be viewed from both sides of the device. When the device is viewed from above the masking grid 11a, at any one instant, the image slices from only one of the images A to E are visible. For example, in the configuration shown in Figure 21, when the device is viewed straight-on, only the image slices forming image E will be visible, and thus the device as a whole will appear to exhibit a complete reproduction of image E. Provided the dimensions of the device are correctly selected, when the device is observed from different angles, different images will become visible. For example, when the device is viewed from position A, only the image slices forming image A will be visible through the masking grid 11a, the device as a whole whereby exhibiting the complete image A. Similarly, when the device is viewed from position C only the image slices forming image C will be visible. As such, as the device is tilted and the viewer observes it at different angles, different stages of the animation will be seen and, provided the images are printed in the correct sequence, an animation will be perceived. In the present example this will appear as a star symbol increasing or decreasing as the device is tilted. Thus, in this case the animation is perceived as a zooming in and out but in other cases the images could be arranged to depict, for example, perceived motion (e.g. a horse galloping), morphing (e.g. a sun changing into a moon) or perceived 3D depth (by providing multiple images of the same object, but from slightly different angles). Of course, in other examples, fewer images (e.g. 2) could be interleaved resulting in a "switch" from one image to another at certain tilt angles, rather than an animation effect.

In order to achieve this effect, the width of each image slice, X, must be smaller than the thickness, t, of the transparent support layer 10, preferably several times smaller, such that there is a high aspect ratio of the thickness t to image slice width X. This is necessary in order that a sufficient portion of the pattern on metal layer 11b can be revealed through tilting of the device. If the aspect ratio were too low, it would be necessary to tilt the device to very high angles before any change in image will be perceived. In a preferred example, each image slice has a width X of the order of 5 to 10 µm, and the thickness t of the support layer 10 is approximately 25 to 35 µm. The use of the above-described demetallisation process to form the pattern 11b is therefore particularly advantageous since the high resolution nature of the process allows the formation of image elements at these small dimensions.

The dimensions of the masking grid 11a are generally larger than those of the pattern elements 11b, requiring opaque stripes of width ((n-1)X) where n is the number of images to be revealed (here, five), spaced by transparent regions of approximately the same width as that of the image slices (X). Thus, in this example the opaque regions 51 of the masking grid 11a have a width of around 20 to 40 µm and hence could alternatively be produced using conventional techniques such as printing.

Figure 22 shows a further embodiment of a venetian blind-type security device in cross-section, comprising first and second patterned metal layers 11a and 11b positioned on either surface of a transparent substrate 10. Metal layer 11a has been demetallised according to a first pattern Pₐ whereas metal layer 11b has been exposed to a second pattern P_{b}. In this example, the device has two laterally offset regions I and II. In region I, the exposed pattern elements of pattern Pₐ and pattern P_{b} are identical and aligned with one another. In area II the patterns Pₐ and P_{b} are identical in pitch but 180° out of phase with one another such that the remaining regions of the first metal layer 11a forming pattern Pₐ align with the removed regions of the second metal layer 11b forming second pattern P_{b}, and vice versa.

When viewed in transmission from directly above, observer (i) will perceive region A as having a lower optical density than region B where light transmission is blocked by the interplay between the two patterns. In contrast, when viewed from an angle at the position of observer (ii), area A will appear relatively dark compared with area B, since light will now be able to pass through aligned transparent regions of patterns Pₐ and P_{b} in area B, whereas it will be blocked by the alignment between pattern elements in area A. This "contrast flip" between areas A and B provides an easily testable, distinctive effect. In order for the switch to be observable at relatively low tilt angles, the aspect ratio of the support layer thickness relative to the spacing of the pattern elements should again be at least one-to-one. It should be noted that it is not essential to ensure an entirely accurate registration between the two patterns Pₐ and P_{b} since provided the sizing of the pattern elements is correct, a switch in contrast between the two regions will still be visible as the device is tilted.

Figure 23 shows a further embodiment of a security device in cross-section which here takes the form of a moire interference device. In this embodiment, two patterned metal layers 11a, 11bare provided as on either side of transparent substrate 10 but as in the previous embodiments, one or other of the patterns provided by the metal layers could be provided by other means such as printing.

To form a moire interference device, each of the metal layers 11a, 11bcarries a pattern of elements, mismatches between the two patterns combining to form moire interference fringes. In the example shown, each of the patterns Pₐ and P_{b} consists of an array of line elements, with those of one pattern rotated relative to those of the other. In other cases, the mismatch could be provided by a pitch variation rather than a rotation, and/or isolated distortions within one or other of the patterns. When viewed from above such that the two patterns are viewed in combination with one another, moire interference bands are visible and these will appear to move relative to the device depending on the viewing angle. This is due to the precise portions of the two patterns which appear to overlap changing as the viewing angle changes. For instance, in the example of Figure 23, when viewed directly from above, portion a of pattern Pₐ will appear to overlap and therefore interfere with portion b of pattern P_{b}, whereas at a second viewing angle illustrated by observer (ii), the same portion a of pattern Pₐ will appear to overlap and therefore interfere with a different portion c of the second pattern P_{b}. In order to achieve significant perceived motion at relatively low viewing angles, a high aspect ratio of the spacing between the two patterns (represented by the thickness t of support layer 10) relative to the spacing s of the line elements in each of the patterns is required. For example, where the line elements have a width and spacing of around 5 µm, a thickness t of around 25 µm is suitable. No registration between the two patterns Pₐ and P_{b} is required.

The security device structures shown in Figures 21, 22 and 23 are preferably formed by carrying out the above-described demetallisation method on both sides of a transparent substrate. Figure 24 shows an example of apparatus which may be used to produce both patterned metal layers. As shown, the substrate provided in step S100 may include a second metal layer 11blocated on the second surface of the substrate 10, which may be of the same composition as the first metal layer 11a, or may be different. Preferably, however, the second metal layer 11b is soluble in the same etchant substance as the first metal layer 11a. A second resist layer 12b is applied over the second metal layer 11b and again this may be of the same composition as the first resist layer 12a or may be different. Both resist layers 12a, 12b are then brought into contact with respective patterning cylinders 7a, 7b each carrying a relief structure 6 in the manner previously described, preferably simultaneously. The two relief structures may be the same as one another or different, and/or may be laterally offset from one another (in the transport path direction and/or in the orthogonal direction), depending on the desired optical effect. Further the nature of the relative motion between the substrate 10 and each relief structure could be the same or could be different. For example, cylinder 7a could be driven at a speed different from that of cylinder 7b. In this example the two relief structures 6 are shown supported on respective opposing cylinders 7a, 7b in a manner correspond to that described above in relation to Figure 1 but alternatively one or both of the relief structures could be provided in the form of a belt.

In still further examples, security devices including those discussed above in relation to Figures 21 to 23 could be formed by producing two demetallised image patterns P on separate transparent substrates 10 using the above described method, and then laminating them together such that the two metal layers are spaced apart by the two transparent substrates.

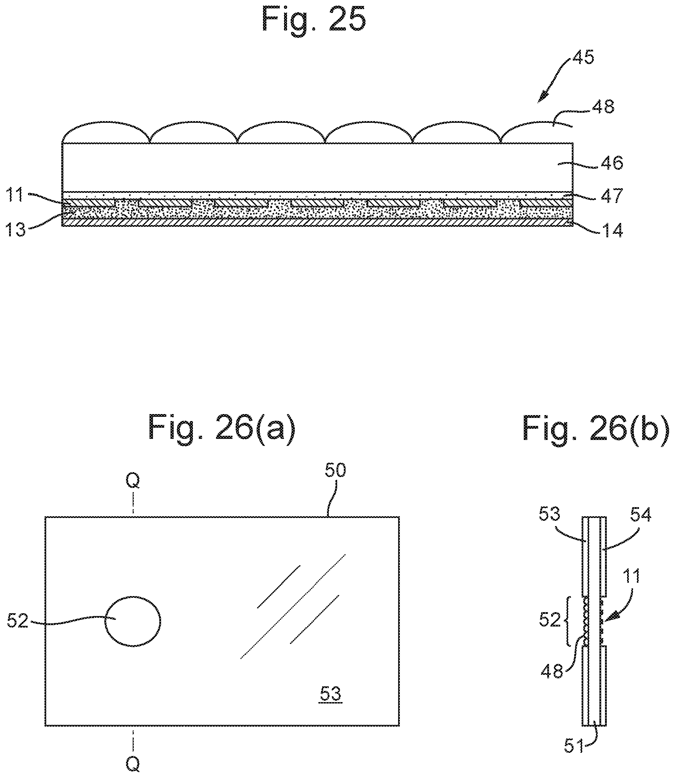

Security devices of the sorts described above are suitable for forming on security articles such as threads, stripes, patches, foils and the like which can then be incorporated into or applied onto security documents such as banknotes and examples of this will be provided further below. However the security devices can also be constructed directly on security documents which are formed of a transparent document substrate, such as polymer banknotes. In such cases, the image pattern may be manufactured on a first substrate, using the method discussed above, and then transferred onto or affixed to one surface of the document substrate, optionally using a transparent adhesive. This may be achieved by foil stamping, for example. An exemplary structure is shown in Figure 25 where substrate 46 is the transparent document substrate, e.g. BOPP, and layer 47 is an adhesive used to join the image array comprising metal layer 11, colour layer 13 and backing layer 14 (all formed previously) to the substrate. Alternatively, the demetallised pattern array could be formed directly on the document substrate 46 by providing a metal layer on the surface of the substrate 46 (optionally across selected portions only), and performing the above-described method on substrate 46 to form an image element array thereon. Focusing element array 48 can be applied to the opposite side of document substrate 46, e.g. by embossing or cast-curing, before or after the image element array is applied.

Security devices of the sorts described above can be incorporated into or applied to any product for which an authenticity check is desirable. In particular, such devices may be applied to or incorporated into documents of value such as banknotes, passports, driving licences, cheques, identification cards etc. The image array and/or the complete security device can either be formed directly on the security document (e.g. on a polymer substrate forming the basis of the security document) or may be supplied as part of a security article, such as a security thread or patch, which can then be applied to or incorporated into such a document.

Such security articles can be arranged either wholly on the surface of the base substrate of the security document, as in the case of a stripe or patch, or can be visible only partly on the surface of the document substrate, e.g. in the form of a windowed security thread. Security threads are now present in many of the world's currencies as well as vouchers, passports, travellers' cheques and other documents. In many cases the thread is provided in a partially embedded or windowed fashion where the thread appears to weave in and out of the paper and is visible in windows in one or both surfaces of the base substrate. One method for producing paper with so-called windowed threads can be found in EP-A-0059056. EP-A-0860298 and WO-A-03095188 describe different approaches for the embedding of wider partially exposed threads into a paper substrate. Wide threads, typically having a width of 2 to 6mm, are particularly useful as the additional exposed thread surface area allows for better use of optically variable devices, such as that presently disclosed.

The security article may be incorporated into a paper or polymer base substrate so that it is viewable from both sides of the finished security substrate at at least one window of the document. Methods of incorporating security elements in such a manner are described in EP-A-1141480 and WO-A-03054297. In the method described in EP-A-1141480, one side of the security element is wholly exposed at one surface of the substrate in which it is partially embedded, and partially exposed in windows at the other surface of the substrate.

Base substrates suitable for making security substrates for security documents may be formed from any conventional materials, including paper and polymer. Techniques are known in the art for forming substantially transparent regions in each of these types of substrate. For example, WO-A-8300659 describes a polymer banknote formed from a transparent substrate comprising an opacifying coating on both sides of the substrate. The opacifying coating is omitted in localised regions on both sides of the substrate to form a transparent region. In this case the transparent substrate can be an integral part of the security device or a separate security device can be applied to the transparent substrate of the document. WO-A-0039391 describes a method of making a transparent region in a paper substrate. Other methods for forming transparent regions in paper substrates are described in EP-A-723501, EP-A-724519, WO-A-03054297 and EP-A-1398174.

The security device may also be applied to one side of a paper substrate, optionally so that portions are located in an aperture formed in the paper substrate. An example of a method of producing such an aperture can be found in WO-A-03054297. An alternative method of incorporating a security element which is visible in apertures in one side of a paper substrate and wholly exposed on the other side of the paper substrate can be found in WO-A-2000/39391.

Examples of such documents of value and techniques for incorporating a security device will now be described with reference to Figures 26 to 29.

Figure 26 depicts an exemplary document of value 50, here in the form of a banknote. Figure 26a shows the banknote in plan view whilst Figure 26b shows a cross-section of the same banknote along the lines X-X'. In this case, the banknote is a polymer (or hybrid polymer/paper) banknote, having a transparent substrate 51. Two opacifying layers 53 and 54 are applied to either side of the transparent substrate 51, which may take the form of opacifying coatings such as white ink, or could be paper layers laminated to the substrate 51.

The opacifying layers 53 and 54 are omitted across a selected region 52 forming a window within which a security device is located. In Figure 26(b), the security device is disposed within window 52, with a focusing element array 48 arranged on one surface of the transparent substrate 51, and image element array 11 on the other (e.g. as in Figure 18 above). As described in relation to Figure 18, the image element array 11 could be manufactured on a separate substrate which is then laminated to the document substrate 51 in the window region, or could be manufactured directly on the document substrate 51 by metallising the substrate 51 (at least in the window region 52, optionally all over the substrate) and then forming a demetallised pattern in the metal layer using the above-described method.

It will be appreciated that, if desired, the window 52 could instead be a "half-window", in which one of the opacifying layers (e.g. 53 or 54) is continued over all or part of the image array 11. Depending on the opacity of the opacifying layers, the half-window region will tend to appear translucent relative to surrounding areas in which opacifying layers 53 and 54 are provided on both sides.

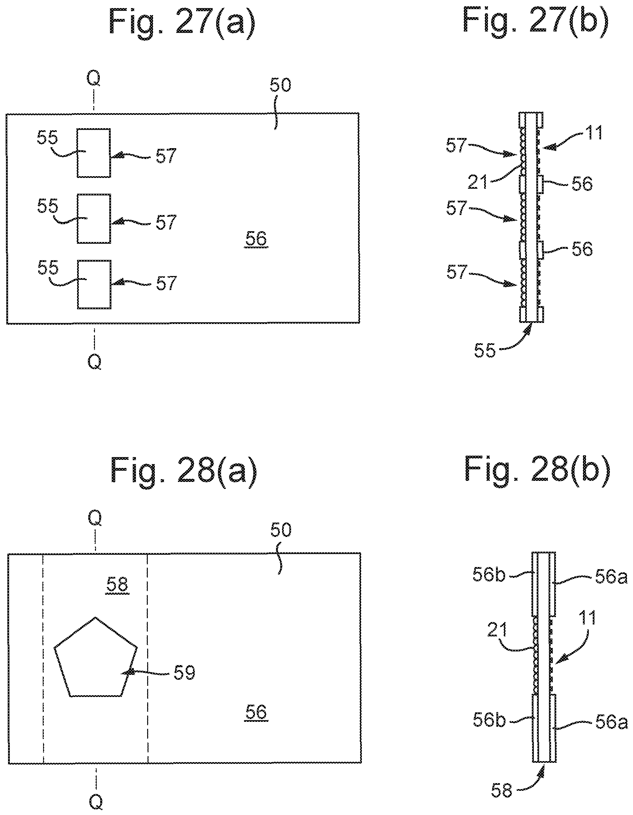

In Figure 27 the banknote 50 is a conventional paper-based banknote provided with a security article 55 in the form of a security thread, which is inserted during paper-making such that it is partially embedded into the paper so that portions of the paper 56 lie on either side of the thread. This can be done using the techniques described in EP0059056 where paper is not formed in the window regions during the paper making process thus exposing the security thread 55 in window regions 57 of the banknote. Alternatively the window regions 57 may for example be formed by abrading the surface of the paper in these regions after insertion of the thread. It should be noted that it is not necessary for the window regions 57 to be "full thickness" windows: the thread 55 need only be exposed on one surface if preferred. The security device is formed on the thread 55, which comprises a transparent substrate a focusing array 21 provided on one side and an image array 11 provided on the other. Windows 57 reveal parts of the device, which may be formed continuously along the thread. Alternatively several security devices could be spaced from each other along the thread, with different or identical images displayed by each.

In Figure 28, the banknote 50 is again a conventional paper-based banknote, provided with a strip element or insert 58. The strip 58 is based on a transparent substrate and is inserted between two plies of paper 56a and 56b. The security device is formed by a lens array 21 on one side of the strip substrate, and an image array 11 on the other. The paper plies 56a and 56b are apertured across region 59 to reveal the security device, which in this case may be present across the whole of the strip 58 or could be localised within the aperture region 59. It should be noted that the ply 56a need not be apertured and could be continuous across the security device.

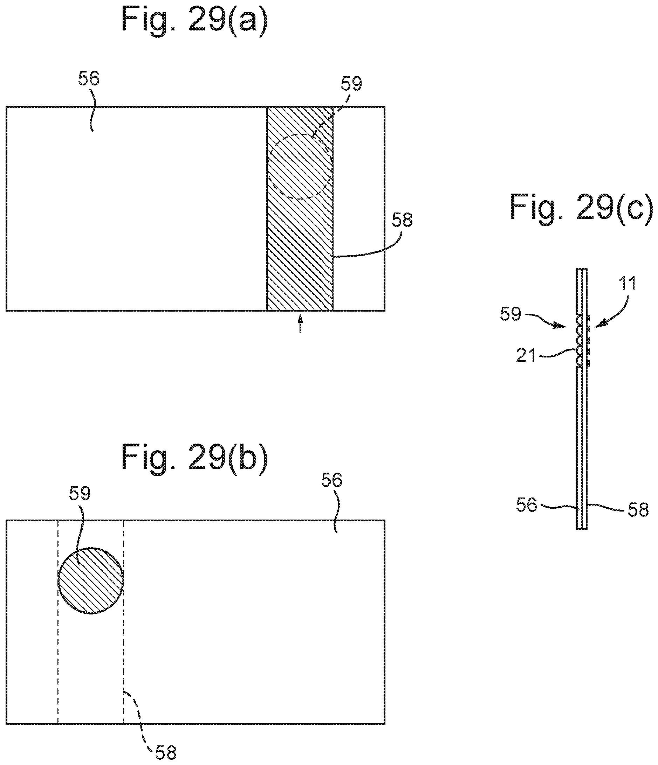

A further embodiment is shown in Figure 29 where Figures 29(a) and (b) show the front and rear sides of the document 50 respectively, and Figure 29(c) is a cross section along line Z-Z'. Security article 58 is a strip or band comprising a security device according to any of the embodiments described above. The security article 58 is formed into a security document 50 comprising a fibrous substrate 56, using a method described in EP-A-1141480. The strip is incorporated into the security document such that it is fully exposed on one side of the document (Figure 29(a)) and exposed in one or more windows 59 on the opposite side of the document (Figure 29(b)). Again, the security device is formed on the strip 58, which comprises a transparent substrate with a lens array 21 formed on one surface and a co-operating image array 11 as previously described on the other

Alternatively a similar construction can be achieved by providing paper 56 with an aperture 59 and adhering the strip element 58 onto one side of the paper 56 across the aperture 59. The aperture may be formed during papermaking or after papermaking for example by die-cutting or laser cutting.

In still further embodiments, a complete security device could be formed entirely on one surface of a security document which could be transparent, translucent or opaque, e.g. a paper banknote irrespective of any window region. The image array 11 can be affixed to the surface of the substrate, e.g. by adhesive or hot or cold stamping, either together with a corresponding focusing element array 20 or in a separate procedure with the focusing array 20 being applied subsequently.

In general when applying a security article such as a strip or patch carrying the security device to a document, it is preferable to bond the article to the document substrate in such a manner which avoids contact between those focusing elements, e.g. lenses, which are utilised in generating the desired optical effects and the adhesive, since such contact can render the lenses inoperative. For example, the adhesive could be applied to the lens array(s) as a pattern that leaves an intended windowed zone of the lens array(s) uncoated, with the strip or patch then being applied in register (in the machine direction of the substrate) so the uncoated lens region registers with the substrate hole or window.

The security device produced according to the current invention can be made machine readable by the introduction of detectable materials in any of the layers or by the introduction of separate machine-readable layers. Detectable materials that react to an external stimulus include but are not limited to fluorescent, phosphorescent, infrared absorbing, thermochromic, photochromic, magnetic, electrochromic, conductive and piezochromic materials.

Additional optically variable devices or materials can be included in the security device such as thin film interference elements, liquid crystal material and photonic crystal materials. Such materials may be in the form of filmic layers or as pigmented materials suitable for application by printing. If these materials are transparent they may be included in the same region of the device as the security feature of the current invention or alternatively and if they are opaque may be positioned in a separate laterally spaced region of the device.

The presence of a metallic layer in the security device can be used to conceal the presence of a machine readable dark magnetic layer, or the metal layer itself could be magnetic. When a magnetic material is incorporated into the device the magnetic material can be applied in any design but common examples include the use of magnetic tramlines or the use of magnetic blocks to form a coded structure. Suitable magnetic materials include iron oxide pigments (Fe₂O₃ or Fe₃O₄), barium or strontium ferrites, iron, nickel, cobalt and alloys of these. In this context the term "alloy" includes materials such as Nickel:Cobalt, lron:Aluminium:Nickel:Cobalt and the like. Flake Nickel materials can be used; in addition Iron flake materials are suitable. Typical nickel flakes have lateral dimensions in the range 5-50 microns and a thickness less than 2 microns. Typical iron flakes have lateral dimensions in the range 10-30 microns and a thickness less than 2 microns.

In an alternative machine-readable embodiment a transparent magnetic layer can be incorporated at any position within the device structure. Suitable transparent magnetic layers containing a distribution of particles of a magnetic material of a size and distributed in a concentration at which the magnetic layer remains transparent are described in WO03091953 and WO03091952.

Negative or positive indicia visible to the naked eye may additionally be created in the metal layer 11 or in any suitable opaque layer, e.g. backing layer 14, either inside or outside the image pattern area.

## Claims

1. A method of manufacturing an image pattern for a security device, the method comprising:
(a) providing a metallised substrate comprising a substrate material (10) having a first metal layer (11) thereon on a first surface of the substrate material, the first metal layer being soluble in a first etchant substance (step S100);
(b) applying a first resist layer (12) to the first metal layer, the first resist layer comprising a resist material (step S102);
(c) bringing the first resist layer (12) into contact with a relief structure (6) comprising a support (7) carrying one or more protrusions (6a) thereon, the one or more protrusions each extending away from the support (7) to a distal tip (6a'), whereupon at least one of the protrusion(s) extends into the first resist layer (12) (step S104);
(d) while the first resist layer (12) and the relief structure (6) are in contact, controlling the metallised substrate and/or the relief structure to achieve relative movement between the metallised substrate and at least the tip (6a') of the at least one of the protrusion(s) along a movement direction, such that the at least one of the protrusion(s) extending into the first resist layer expels a corresponding at least one portion of the resist material from a corresponding at least one region (P₂) of the metallised substrate (step S106);
(e) separating the first resist layer (12) from the relief structure (6) such that the at least one of the protrusion(s) is removed from the first resist layer, leaving the resist material remaining on the metallised substrate outside the at least one region, thereby forming a pattern of one or more first pattern elements (P₁) in which the resist material is present and one or more second pattern elements (P₂), corresponding to the at least one region, in which the resist material is substantially absent (step S108); and
(f) applying the first etchant substance to the metallised substrate whereupon the second pattern elements of the first metal layer are dissolved, the remaining first pattern elements of the first metal layer forming an image pattern (step S110).

2. A method according to claim 1, wherein the resist material (12) is a curable resist material, preferably a radiation-curable resist material or a heatcurable resist material.

3. A method according to claim 1 or 2, further comprising, during or after steps (d) and/or (e) and before step (f), curing the resist material (12) remaining on the metallised substrate outside the first region(s).

4. A method according to any of the preceding claims, wherein in step (b) the first resist layer (12) is applied to a thickness which is less than or equal to the height of the at least one protrusion (6a) of the relief structure (6).

5. A method according to any of the preceding claims, wherein in step (b), the resist material (12) has a first viscosity level when applied to the metallised substrate to form the resist layer, and step (b) further includes subsequently increasing the viscosity of the resist material to a second viscosity level.

6. A method according to any of the preceding claims, wherein the resist material is a curable material, further comprising, after step (b) and before step (c):
(b1) partially pre-curing the first resist layer.

7. A method according to any of the preceding claims, wherein the one or more protrusions (6a) each have a base (6a") on the support and a distal tip (6a'), the sides of the protrusion being angled on each side of the tip such that the tip is pointed, the sides preferably being straight at the point of intersection so as to form a sharp tip.

8. A method according to any of the preceding claims, wherein the one or more protrusions (6a) each have a lateral shape of which at least part is arranged along a direction which is not parallel with the movement direction.

9. A method according to any of the preceding claims, wherein the one or more protrusions (6a) comprises a plurality of protrusions, preferably arranged in a periodic manner on the support.

10. A method according to any of the preceding claims, wherein the one or more protrusions (6a) each have a base (6a") on the support and a distal tip (6a'), at least the tip of the protrusion being formed of a flexible material such that the tip (6a') deforms during step (d), more preferably the whole of each protrusion (6a) being formed of a flexible material, the flexible material preferably comprising an elastomer.

11. A method according to any of the preceding claims, wherein during step (d) a pressure applied between the relief structure (6) and the metallised substrate is sufficient that the tip(s) of the at least one protrusion extends through the first resist layer (12) and contacts the first metal layer (11), wherein preferably the one or more protrusions (6a) each have a base (6a") on the support and a distal tip (6a'), at least the tip of the protrusion being formed of a flexible material such that the tip deforms during step (d) and during step (d) the pressure applied between the relief structure (6) and the metallised substrate is such that the tip(s) of the at least one protrusion are deformed against the first metal layer (11), thereby causing relative movement between the tip(s) of the at least one protrusion and the metallised substrate.

12. A method according to any of the preceding claims, wherein the one or more second pattern elements (P₂) have a dimension in the movement direction of 50 µm (microns) or less, preferably 30 µm (microns) or less, more preferably 10 µm (microns) or less, most preferably 5 µm (microns) or less.

13. A method according to any of the preceding claims, wherein the pattern of first and second pattern elements (P₁, P₂) is periodic in at least a first dimension and either the first pattern elements are substantially identical to one another and/or the second pattern elements are substantially identical to one another.

14. A method according to any of claims 1 to 13, wherein the pattern of first and second pattern elements (P₁, P₂) defines sections of at least two images interleaved with one another periodically in at least a first dimension, each section preferably having a width of 50 µm (microns) or less in at least the first dimension, more preferably 30 µm (microns) or less, most preferably 20 µm (microns) or less.

15. A method of manufacturing a security device, comprising:
(i) manufacturing a first image pattern using the method of any of claims 1 to 14; and
(ii) providing a viewing component (20, 11a) overlapping the first image pattern;
wherein the first image pattern and the viewing component are configured to co-operate to generate an optically variable effect.

## Patentansprüche

1. Verfahren zum Fertigen eines Bildmusters für eine Sicherheitsvorrichtung, wobei das Verfahren Folgendes umfasst:
(a) Bereitstellen eines metallisierten Substrats, das ein Substratmaterial (10) umfasst, das eine erste Metallschicht (11) darauf auf einer ersten Oberfläche des Substratmaterials aufweist, wobei die erste Metallschicht in einer ersten Ätzmittelsubstanz löslich ist (Schritt S100);
(b) Aufbringen einer ersten Resistschicht (12) auf die erste Metallschicht, wobei die erste Resistschicht ein Resistmaterial umfasst (Schritt S102);
(c) Inberührungbringen der ersten Resistschicht (12) mit einer Reliefstruktur (6), die einen Träger (7) umfasst, der einen oder mehrere Vorsprünge (6a) darauf trägt, wobei sich der eine oder die mehreren Vorsprünge jeweils von dem Träger (7) weg zu einer distalen Spitze (6a') erstrecken, woraufhin sich wenigstens einer des Vorsprungs/der Vorsprünge in die erste Resistschicht (12) erstreckt (Schritt S104);
(d) während die erste Resistschicht (12) und die Reliefstruktur (6) in Berührung sind, Steuern des metallisierten Substrats und/oder der Reliefstruktur, um eine Relativbewegung zwischen dem metallisierten Substrat und wenigstens der Spitze (6a') des wenigstens einen des Vorsprungs/der Vorsprünge entlang einer Bewegungsrichtung zu erreichen, sodass der wenigstens eine des Vorsprungs/der Vorsprünge, der sich in die erste Resistschicht erstreckt, einen entsprechenden wenigstens einen Abschnitt des Resistmaterials aus einer entsprechenden wenigstens einen Region (P₂) des metallisierten Substrats ausstößt (Schritt S106);
(e) Trennen der ersten Resistschicht (12) von der Reliefstruktur (6), sodass der wenigstens eine des Vorsprungs/der Vorsprünge von der ersten Resistschicht entfernt wird, wobei das Resistmaterial auf dem metallisierten Substrat verbleibend außerhalb der wenigstens einen Region hinterlassen wird, wobei dadurch ein Muster aus einem oder mehreren ersten Musterelementen (P₁), in denen das Resistmaterial vorhanden ist, und einem oder mehreren zweiten Musterelementen (P₂) ausgebildet wird, die der wenigstens einen Region entsprechen, in denen das Resistmaterial im Wesentlichen abwesend ist (Schritt S108); und
(f) Aufbringen der ersten Ätzmittelsubstanz auf das metallisierte Substrat, woraufhin die zweiten Musterelemente der ersten Metallschicht aufgelöst werden, wobei die verbleibenden ersten Musterelemente der ersten Metallschicht ein Bildmuster ausbilden (Schritt S110).

2. Verfahren nach Anspruch 1, wobei das Resistmaterial (12) ein härtbares Resistmaterial ist, bevorzugt ein strahlungshärtbares Resistmaterial oder ein wärmehärtbares Resistmaterial.

3. Verfahren nach Anspruch 1 oder 2, das ferner während oder nach Schritten (d) und/oder (e) und vor Schritt (f) ein Härten des Resistmaterials (12) umfasst, das auf dem metallisierten Substrat außerhalb der ersten Region(en) verbleibt.

4. Verfahren nach einem der vorhergehenden Ansprüche, wobei in Schritt (b) die erste Resistschicht (12) in einer Dicke aufgebracht wird, die kleiner als oder gleich der Höhe des wenigstens einen Vorsprungs (6a) der Reliefstruktur (6) ist.

5. Verfahren nach einem der vorhergehenden Ansprüche, wobei in Schritt (b) das Resistmaterial (12) einen ersten Viskositätswert aufweist, wenn es auf das metallisierte Substrat aufgebracht wird, um die Resistschicht auszubilden, und Schritt (b) ferner ein anschließendes Erhöhen der Viskosität des Resistmaterials auf einen zweiten Viskositätswert beinhaltet.

6. Verfahren nach einem der vorhergehenden Ansprüche, wobei das Resistmaterial ein härtbares Material ist, das ferner nach Schritt (b) und vor Schritt (c) Folgendes umfasst:
(b1) teilweises Vorhärten der ersten Resistschicht.

7. Verfahren nach einem der vorhergehenden Ansprüche, wobei der eine oder die mehreren Vorsprünge (6a) jeweils eine Basis (6a") auf dem Träger und eine distale Spitze (6a') aufweisen, wobei die Seiten des Vorsprungs auf jeder Seite der Spitze abgewinkelt sind, sodass die Spitze zugespitzt ist, wobei die Seiten bevorzugt an dem Schnittpunkt gerade sind, um eine scharfe Spitze auszubilden.

8. Verfahren nach einem der vorhergehenden Ansprüche, wobei der eine oder die mehreren Vorsprünge (6a) jeweils eine seitliche Form aufweisen, von denen wenigstens ein Teil entlang einer Richtung angeordnet ist, die nicht parallel zu der Bewegungsrichtung ist.

9. Verfahren nach einem der vorhergehenden Ansprüche, wobei der eine oder die mehreren Vorsprünge (6a) mehrere Vorsprünge umfassen, die bevorzugt auf eine periodische Weise auf dem Träger angeordnet sind.

10. Verfahren nach einem der vorhergehenden Ansprüche, wobei der eine oder die mehreren Vorsprünge (6a) jeweils eine Basis (6a") auf dem Träger und eine distale Spitze (6a') aufweisen, wobei wenigstens die Spitze des Vorsprungs aus einem flexiblen Material ausgebildet ist, sodass sich die Spitze (6a') während Schritt (d) verformt, stärker bevorzugt die Gesamtheit jedes Vorsprungs (6a) aus einem flexiblen Material ausgebildet ist, wobei das flexible Material bevorzugt ein Elastomer umfasst.

11. Verfahren nach einem der vorhergehenden Ansprüche, wobei während Schritt (d) ein Druck, der zwischen der Reliefstruktur (6) und dem metallisierten Substrat aufgebracht wird, ausreicht, dass sich die Spitze(n) des wenigstens einen Vorsprungs durch die erste Resistschicht (12) erstreckt/erstrecken und die erste Metallschicht (11) berührt/berühren, wobei bevorzugt der eine oder die mehreren Vorsprünge (6a) jeweils eine Basis (6a") auf dem Träger und eine distale Spitze (6a') aufweisen, wobei wenigstens die Spitze des Vorsprungs aus einem flexiblen Material ausgebildet ist, sodass sich die Spitze während Schritt (d) verformt, und während Schritt (d) der Druck, der zwischen der Reliefstruktur (6) und dem metallisierten Substrat aufgebracht wird, so ist, dass die Spitze(n) des wenigstens einen Vorsprungs gegen die erste Metallschicht (11) verformt wird/werden, wobei dadurch eine Relativbewegung zwischen der/den Spitze(n) des wenigstens einen Vorsprungs und dem metallisierten Substrat bewirkt wird.

12. Verfahren nach einem der vorhergehenden Ansprüche, wobei das eine oder die mehreren zweiten Musterelemente (P₂) eine Dimension in der Bewegungsrichtung von 50 µm (Mikrometer) oder weniger, bevorzugt 30 µm (Mikrometer) oder weniger, stärker bevorzugt 10 µm (Mikrometer) oder weniger, am stärksten bevorzugt 5 µm (Mikrometer) oder weniger aufweisen.

13. Verfahren nach einem der vorhergehenden Ansprüche, wobei das Muster der ersten und der zweiten Musterelemente (P₁, P₂) in wenigstens einer ersten Dimension periodisch ist und entweder die ersten Musterelemente im Wesentlichen identisch zueinander sind und/oder die zweiten Musterelemente im Wesentlichen identisch zueinander sind.

14. Verfahren nach einem der Ansprüche 1 bis 13, wobei das Muster der ersten und der zweiten Musterelemente (P₁, P₂) Bereiche von wenigstens zwei Bildern definiert, die in wenigstens einer ersten Dimension periodisch miteinander verschachtelt sind, wobei jeder Bereich bevorzugt eine Breite von 50 µm (Mikrometer) oder weniger in wenigstens der ersten Dimension, stärker bevorzugt 30 µm (Mikrometer) oder weniger, am stärksten bevorzugt 20 µm (Mikrometer) oder weniger aufweist.

15. Verfahren zum Fertigen einer Sicherheitsvorrichtung, die Folgendes umfasst:
(i) Fertigen eines ersten Bildmusters unter Verwendung des Verfahrens nach einem der Ansprüche 1 bis 14; und
(ii) Bereitstellen einer Betrachtungskomponente (20, 11a), die das erste Bildmuster überlappt;
wobei das erste Bildmuster und die Betrachtungskomponente konfiguriert sind, um zusammenzuarbeiten, um einen optisch variablen Effekt zu erzeugen.

## Revendications

1. Procédé de fabrication de motif d'image pour un dispositif de sécurité, le procédé comprenant :
(a) la fourniture d'un substrat métallisé comprenant un matériau de substrat (10) ayant une première couche métallique (11) sur ce dernier sur une première surface du matériau de substrat, la première couche métallique étant soluble dans une première substance d'agent d'attaque chimique (étape S100) ;
(b) l'application d'une première couche de réserve (12) sur la première couche métallique, la première couche de réserve comprenant un matériau de réserve (étape S102) ;
(c) la mise en contact de la première couche de réserve (12) avec une structure en relief (6) comprenant un support (7) portant une ou plusieurs protubérances (6a) sur ce dernier, la ou les protubérances s'étendant chacune à l'écart du support (7) vers une pointe distale (6a'), sur laquelle au moins l'une des protubérances s'étend dans la première couche de réserve (12) (étape S104) ;
(d) pendant que la première couche de réserve (12) et la structure en relief (6) sont en contact, la commande du substrat métallisé et/ou de la structure en relief pour obtenir un mouvement relatif entre le substrat métallisé et au moins la pointe (6a') de l'au moins une des protubérances le long d'une direction de mouvement, de telle sorte que l'au moins une des protubérances s'étendant dans la première couche de réserve expulse au moins une partie correspondante du matériau de réserve à partir d'au moins une région correspondante (P₂) du substrat métallisé (étape S106) ;
(e) la séparation de la première couche de réserve (12) de la structure en relief (6) de telle sorte qu'au moins une des protubérances est retirée de la première couche de réserve, laissant le matériau de réserve restant sur le substrat métallisé à l'extérieur de l'au moins une région, formant ainsi un motif d'un ou plusieurs premiers éléments de motif (Pi) dans lesquels le matériau de réserve est présent et un ou plusieurs seconds éléments de motif (P₂), correspondant à l'au moins une région, dans lesquels le matériau de réserve est sensiblement absent (étape S108) ; et
(f) l'application de la première substance d'agent d'attaque chimique au substrat métallisé, sur lequel les seconds éléments de motif de la première couche métallique sont dissous, les premiers éléments de motif restants de la première couche métallique formant un motif d'image (étape S110).

2. Procédé selon la revendication 1, le matériau de réserve (12) étant un matériau de réserve durcissable, de préférence un matériau de réserve durcissable par rayonnement ou un matériau de réserve thermodurcissable.

3. Procédé selon la revendication 1 ou 2, comprenant en outre, pendant ou après les étapes (d) et/ou (e) et avant l'étape (f), le durcissement du matériau de réserve (12) restant sur le substrat métallisé à l'extérieur de la ou des premières régions.

4. Procédé selon l'une quelconque des revendications précédentes, à l'étape (b) la première couche de réserve (12) étant appliquée à une épaisseur qui est inférieure ou égale à la hauteur de l'au moins une protubérance (6a) de la structure en relief (6).

5. Procédé selon l'une quelconque des revendications précédentes, à l'étape (b), le matériau de réserve (12) ayant un premier niveau de viscosité lorsqu'il est appliqué au substrat métallisé pour former la couche de réserve, et l'étape (b) comportant en outre l'augmentation subséquente de la viscosité du matériau de réserve à un second niveau de viscosité.

6. Procédé selon l'une quelconque des revendications précédentes, le matériau de réserve étant un matériau durcissable, comprenant en outre, après l'étape (b) et avant l'étape (c) :
(b1) le prédurcissement partiel de la première couche de réserve.

7. Procédé selon l'une quelconque des revendications précédentes, la ou les protubérances (6a) ayant chacune une base (6a") sur le support et une pointe distale (6a'), les côtés de la protubérance étant inclinés de chaque côté de la pointe de telle sorte que la pointe est pointue, les côtés étant de préférence rectilignes au point d'intersection de manière à former une pointe aiguë.

8. Procédé selon l'une quelconque des revendications précédentes, la ou les protubérances (6a) ayant chacune une forme latérale dont au moins une partie est disposée le long d'une direction qui n'est pas parallèle à la direction de mouvement.

9. Procédé selon l'une quelconque des revendications précédentes, la ou les protubérances (6a) comprenant une pluralité de protubérances, de préférence disposées de manière périodique sur le support.

10. Procédé selon l'une quelconque des revendications précédentes, la ou les protubérances (6a) ayant chacune une base (6a") sur le support et une pointe distale (6a'), au moins la pointe de la protubérance étant formée d'un matériau souple de telle sorte que la pointe (6a') se déforme lors de l'étape (d), plus préférablement l'ensemble de chaque protubérance (6a) étant formé d'un matériau souple, le matériau souple comprenant de préférence un élastomère.

11. Procédé selon l'une quelconque des revendications précédentes, pendant l'étape (d) une pression appliquée entre la structure en relief (6) et le substrat métallisé étant suffisante pour que la ou les pointes de l'au moins une protubérance s'étende à travers la première couche de réserve (12) et entre en contact avec la première couche métallique (11), de préférence la ou les protubérances (6a) ayant chacune une base (6a") sur le support et une pointe distale (6a'), au moins la pointe de la protubérance étant formée d'un matériau souple de telle sorte que la pointe se déforme pendant l'étape (d), et pendant l'étape (d) la pression appliquée entre la structure en relief (6) et le substrat métallisé étant telle que la ou les pointes de l'au moins une protubérance sont déformées contre la première couche métallique (11), provoquant ainsi un mouvement relatif entre la ou les pointes de l'au moins une protubérance et le substrat métallisé.

12. Procédé selon l'une quelconque des revendications précédentes, le ou les seconds éléments de motif (P₂) ayant une dimension dans la direction de mouvement égale ou inférieure à 50 µm (microns), de préférence égale ou inférieure à 30 µm (microns), plus préférablement égale ou inférieure à 10 µm (microns), le plus préférablement égale ou inférieure à 5 µm (microns).

13. Procédé selon l'une quelconque des revendications précédentes, le motif des premier et second éléments de motif (P₁, P₂) étant périodique dans au moins une première dimension et les premiers éléments de motifs étant sensiblement identiques les uns aux autres et/ou les seconds éléments de motif étant sensiblement identiques les uns aux autres.

14. Procédé selon l'une quelconque des revendications 1 à 13, le motif des premier et second éléments de motif (P₁, P₂) définissant des sections d'au moins deux images entrelacées les unes avec les autres périodiquement dans au moins une première dimension, chaque section ayant de préférence une largeur égale ou inférieure à 50 µm (microns) dans au moins la première dimension, plus préférablement égale ou inférieure à 30 µm (microns), le plus préférablement égale ou inférieure à 20 µm (microns).

15. Procédé de fabrication d'un dispositif de sécurité, comprenant :
(i) la fabrication d'un premier motif d'image à l'aide du procédé selon l'une quelconque des revendications 1 à 14 ; et
(ii) la fourniture d'un composant de visualisation (20, 11a) chevauchant le premier motif d'image ;
le premier motif d'image et le composant de visualisation étant configurés pour coopérer afin de générer un effet optiquement variable.
